# EUROPEAN PATENT APPLICATION

(11) **EP 4 723 821 A1**
(43) Date of publication of application: **08.04.2026**
(21) Application number: 25206693.1
(22) Date of filing: 03.10.2025
(51) Int. Cl.: H05K 7/20, H10W 40/22

(54) **COLD PLATE WITH CONTROLLED DEFORMATION**

(30) Priority: 04.10.2024 US 202463703629 P; 29.04.2025 US 202519193710
(71) Applicant: Nvidia Corporation, Santa Clara, CA 95051 (US)
(72) Inventor: FRANZ, John, Santa Clara, 95051 (US); CADER, Tahir, Santa Clara, 95051 (US); SLABY, Matthew Richard, Santa Clara, 95051 (US); GORLA, Gabriele, Santa Clara, 95051 (US); HALEY, David Brien, Santa Clara, 95051 (US); KULKARNI, Amit, Santa Clara, 95051 (US); BELL, Andrew, Santa Clara, 95051 (US); MENTOVICH, Elad, Santa Clara, 95051 (US); WELLS, Ryan, Santa Clara, 95051 (US); FEDERICO, Giovanni, Santa Clara, 95051 (US); SETTER, Eyal, Santa Clara, 95051 (US)
(74) Representative: Mathys & Squire

(57) **Abstract**

A deformation assembly, in at least one aspect, may support a cold plate assembly or may be part of the cold plate assembly which includes a cold plate. The deformation assembly may allow a controlled deformation to the cold plate. The controlled deformation may deform the cold plate to a predetermined curvature of a computing component.

## Description

### CROSS-REFERENCE TO RELATED APPLICATION(S)

This is a non-provisional application that is related to and that claims the benefit of priority from U.S. provisional patent application Ser. No. 63/703,629, filed October 4, 2024, and entitled "FLEXIBLE COLD PLATE ASSEMBLY," the entire contents of which is incorporated by reference herein and form a part of this specification for all intents and purposes.

### TECHNICAL FIELD

This disclosure generally relates to cooling computing components and, in at least one aspect, specifically relates to cold plates with controlled deformation therein for cooling computing components.

### BACKGROUND

Computer environments such as datacenters may be subject to liquid cooling. Liquid cooling may use cold plates to interface with computing components of a computer module.

### SUMMARY

The invention is defined by the claims. In order to illustrate the invention, aspects and embodiments which may or may not fall within the scope of the claims are described herein.

A deformation assembly, in at least one aspect, may support a cold plate assembly or may be part of the cold plate assembly which includes a cold plate. The deformation assembly may allow a controlled deformation to the cold plate. The controlled deformation may deform the cold plate to a predetermined curvature of a computing component.

Any feature of one aspect or embodiment may be applied to other aspects or embodiments, in any appropriate combination. In particular, any feature of a method aspect or embodiment may be applied to an apparatus aspect or embodiment, and vice versa.

### BRIEF DESCRIPTION OF DRAWINGS

FIG. 1A is an exploded view of a deformation assembly to support a cold plate assembly or to be part of the cold plate assembly, in at least one embodiment;
FIG. 1B is an exploded view of a deformation assembly having a top plate, a bottom plate, and a bottom profile with a predetermined curvature to allow a controlled deformation to a cold plate, in at least one embodiment;
FIG. 1C is an assembled view of a deformation assembly, with an allowance in the top plate for a pressure-based sub-system, in at least one embodiment;
FIG. 1D is a cross-section view of a deformation assembly, with a plug over the allowance in the top plate, in at least one embodiment;
FIG. 1E is an exploded view of a deformation assembly that is part of a cold plate assembly over a computing component, with a plug over the allowance in the top plate, in at least one embodiment;
FIG. 1F is an illustration of a process sequence of a deformation assembly to associate with the cold plate and to allow a mechanical shaping at a bottom surface of a base plate of the cold plate to allow a predetermined curvature for the cold plate, in at least one embodiment;
FIG. 1G is an illustration of another process sequence of a deformation assembly to include one or more spacers, a bonding material, and an allowance for one or more of a mechanical sub-system or a pressure-based sub-system to allow a predetermined curvature for a cold plate, in at least one embodiment;
FIG. 1H is an illustration of a flexible cold plate having heat removal surface extensions, discontinuities within the heat removal surface extensions, and a thin base plate, in at least one embodiment;
FIG. 1I is an illustration of a datacenter subject to the flexible cold plate assembly of FIG. 1H, in at least one embodiment;
FIG. 2A is an illustration of computer module aspects of a flexible cold plate assembly, in at least one embodiment;
FIG. 2B is an illustration of cross-section aspects of a flexible cold plate assembly, in at least one embodiment;
FIG. 2C is an illustration of further aspects of a flexible cold plate assembly, in at least one embodiment;
FIG. 2D is an illustration of cross-sectional and plan view aspects of heat removal surface extensions and discontinuities that are perpendicular to a direction of flow of a fluid through the heat removal surface extensions in a flexible cold plate assembly, in at least one embodiment;
FIG. 2E is an illustration of cross-sectional view aspects of a distribution seal having a top distribution seal portion and a bottom distribution seal portion, in at least one embodiment;
FIG. 3A is an illustration of a flexible cold plate assembly with a distribution seal having flow restrictions to block or limit fluid from reaching portions of the flexible cold plate in a flexible cold plate assembly, in at least one embodiment;
FIG. 3B is a detailed illustration of a flexible cold plate assembly with a distribution seal having a spring between a top plate and a bottom plate to perform further conforming or flexing in the distribution seal of a flexible cold plate assembly, in at least one embodiment;
FIG. 3C is an illustration of features to provide conformance or flexing in boundary areas of a flexible cold plate, in at least one embodiment;
FIG. 4 illustrates rack aspects in a system subject to a flexible cold plate assembly, according to at least one embodiment;
FIG. 5A illustrates a process flow for a deformation assembly to include a cold plate and to allow a controlled deformation to the cold plate, in at least one embodiment;
FIG. 5B illustrates a process flow for a system having at least one flexible cold plate assembly, in at least one embodiment;
FIG. 5C illustrates yet another process flow for a system having at least one flexible cold plate assembly, in at least one embodiment;

### DETAILED DESCRIPTION

A problem addressed herein is that a thermal interface material (TIM), which may be used between a cold plate and silicon features of a die, a chip, or other silicon package (altogether referred to herein as a computing feature, device, or component), may be grease-based and may be mismatched in a coefficient of thermal expansion (CTE) with respect to the cold plate and the computing component. There may be relative motions of the cold plate and computing component as a cold plate assembly heats up and cools down during performance of a workload. These relative motions may cause the TIM to pump out of a gap between the surfaces of the cold plate and the computing component. These relative motions may also make it difficult to control a bond-line thickness, which may be a thickness of the TIM between the cold plate and the die. Metal solder TIMs may be displaced during the bonding process when pressure is applied from the cold plate down through the computing component. The movement of material may result in air voids and poor performance, but may also cause unpredictable behaviors for the computing component. In addition, the thermal interface materials may be impacted from flat and rigid cold plates attached to a curved surface of a computing component as solder displacement may be accentuated.

A solution to the problem may be provided, at least in part, by a cold plate assembly having controlled deformation to match a curvature profile of a computing component (e.g. silicon die warpage or silicon printed circuit assembly) and to support a uniform thermal bond-line. When the cold plate is bonded to the computing component, the matching curvature profile allows an optimum thermal bonding process because the forces are minimized and material is not pushed and displaced. Reference to controlled deformation herein is with respect to an intended or pre-determined deformation, which may include a curvature, caused to a base plate in a cold plate assembly based in part on a curvature of a computing device. The reference to control in the controlled deformation herein may be based in part on use of an external mechanical, including pressure-based, sub-system to impart the deformation by control input to the subs-system to generate forces from an external environmental air pressure deformation, for instance. In one example, the solution to the problem may use a flexible cold plate with fins that may have discontinuities to support flexibility of the base plate, during the controlled deformation imparted to the base plate to match a curvature of a computing component and to support a uniform thermal bond-line. The controlled deformation, in one example, may be provided for a cold plate or for a cold plate assembly, using a deformation assembly to support a cold plate assembly or to be part of the cold plate assembly.

The thin and flexible base forming the base plate allows for improved cooling of silicon features of the computing components or components by control of the bond-line thickness of the TIM and to achieve a uniform and controlled bond-line. In one example, the TIM achieved is a thin layer in the order of thickness that may be based at least in part on the thickness of the base plate. For example, the TIM is allowed to be a thin layer in a range which is one of: less than 100 microns, 100 microns to 200 microns, 200 microns to 300 microns, 300 microns to 400 microns, or 400 microns to 500 microns.

In one example, for the deformation assembly to be part of the cold plate assembly, a portion of the deformation assembly may remain with the cold plate as part of the cold plate assembly. In another example, for the deformation assembly to support a cold plate assembly, the deformation assembly may allow the cold plate to be controllably deformed in the deformation assembly, may allow the cold plate to be removed from the deformation assembly, and may allow the cold plate, as controllably deformed, to be provided within a cold plate assembly. The controlled deformation may cause the cold plate to deform into or as part of the deformation assembly. When a flexible cold plate is subject to controlled deformation and used with a cold plate assembly, such a cold plate assembly may be referred to herein as a flexible cold plate assembly.

The controlled deformation may represent a curvature of a computing component and may support a uniform thermal bond-line with the computing component. The cold plate, once controllably deformed, may be bonded to the computing component for a thermal connection that may have predetermined measures that are over measures of thermal connection in an other non-controllably deformed computing component. Further, a predetermined curvature of the computing component may be used in the deformation assembly to achieve the controlled deformation for the computing component. A modelling of a curvature of the computing component may be used to prepare the predetermined curvature. For instance, an optical (or other) modeling may be performed to scan the computing component and to generate a detailed distribution map of its curvature surface, for generating a matching surface on the cold plate which may be used to prepare the deformation assembly. In another example, the modelling of the curvature may be performed by a mechanical measurement over a surface of the computing component. The mechanical measurement may be used to generate a detailed distribution map of the curvature surface.

In one example, the deformation assembly may include a top plate and a bottom plate, with the bottom plate having a bottom profile. The bottom profile may be of a predetermined curvature. In one example, the top plate and the bottom plate may be a single integrated plate with the bottom profile provided to the single integrated plate. The deformation assembly may be such that it is part of the cold plate assembly having the cold plate. In this example, a pressure-based sub-system may be used to provide negative, zero, or positive pressure (such as vacuum or sub-atmospheric pressure, atmospheric pressure, or high pressure or super-atmospheric pressure, relative to an external atmospheric pressure) to suction the cold plate against the bottom profile and to cause the cold plate to deform inward. In one example, maintaining positive, zero, or negative pressure may represent part of an active system for the deformation assembly. For example, when the deformation assembly is subject to an oven to melt an applied solder, air inside the cold plate may be heat and may expand. This expansion may increase an internal pressure in the deformation assembly. To control the deformation in the deformation assembly, control of the pressure may be performed. In some examples, a zero pressure change may be an atmospheric pressure maintained to the deformation assembly having the base plate of the cold plate.

The top plate, the bottom plate, and the cold plate may remain with the computing component when the computing component is used to perform a workload (or the cold plate may be removed and may be used in a cold plate assembly with the computing component). The deformation assembly being part of the cold plate assembly may provide additional benefits of, for example, allowing further and periodic vacuum or high-pressure application to the sealed cavity, through the valved connection port of the pressure-based sub-system. The port allows the pressure to be applied to an internal cavity of a cold plate may cause a bottom metal surface of the cold plate to controllably deform based at least in part on the pressure being applied and a shape of the bottom profile, for instance.

As vacuum or high-pressure may cause an internal pressure that is lower or higher than the external atmospheric pressure within the deformation assembly, the base plate may be controllably deformed against the bottom profile of the deformation assembly and may be used after deformation with a cold plate assembly. The base plate may be thin and flexible to be able to accommodate the controllable deformation caused to it. In one example, as used herein, the base plate being thin, as used herein, may be so referenced at least in part for including a dimension or thickness in the base plate that is in a range which is one of: 150 microns to 200 microns, 200 microns to 300 microns, 300 microns to 400 microns, or 400 microns to 500 microns. The base plate has, thereon, heat removal surface extensions, which may be microchannels, in one example.

In another example, the base plate being flexible may be based in part on the base plate being thin but may be also based in part on the heat removal surface extensions having discontinuities therein. The base plate being thin and flexible also allows the cold plate to be thin and flexible. The cold plate assembly may have a top plate that may be provided from a stiff structure. The stiff structure may be so that the top plate does not deform under the pressures applied to allow the controlled deformation, when the top plate is used as part of a deformation assembly. The inside surface of the bottom plate may be machined to provide the bottom profile having an upward curvature.

The bottom profile may also be offset, from top features of the heat removal surface extensions, by a few hundred microns. This offset may allow the controlled deformation of the thin base plate without any deformation to the heat removal surface extensions. A valved connection port of the pressure-based sub-system allows the deformation assembly to maintain the predetermined curvature for a computing component, and once achieved, the deformation assembly as a whole may be placed on top of a surface of the computing component as part of a cold plate assembly.

In another example, the deformation assembly may be distinct from the cold plate assembly. The deformation assembly may be include on a mechanical sub-system (e.g. compression plate) with a bottom plate having a bottom profile of the predetermined curvature of the computing component. The mechanical system with the bottom plate may support a mechanically applied force or load, as the controlled deformation, to cause the cold plate to deform to the bottom profile of the bottom plate. In some embodiments, the mechanical sub-system applies even pressure across the cold plate base ensuring uniform deformation. The cold plate may be removed from the deformation assembly and applied to the computing component as part of the cold plate assembly. The mechanical sub-system may be used as a pre-curving tool to plastically deform the base plate through the mechanically applied force or load, prior to installation on the computing component (e.g. assembly). This tool exceeds the required deformation to account for material spring back, ensuring the cold plate matches the die curvature. In this example, the mechanically applied force or load may need to be monitored to ensure that the base plate and the heat removal surface extension are not pushed and/or deformed beyond operating deflections to achieve predetermined deformation.

In yet another example, the deformation assembly may include a top plate associated with a cold plate base and to allow mechanical shaping (machining) at a bottom surface of the cold plate as part of the controlled deformation applied. The mechanical shaping may be performed by a physical cutting or other deforming applied to only the bottom surface of the cold plate, before the cold plate is applied to the computing component, as part of the cold plate assembly. There may be no pressure used in this example and the cold plate need not be flexible. In this example, a non-flat surface may be created through the machining process of the base plate of the cold plate. While the thin and flexible base plate may have sufficient material, the machining is performed by controlling the process to ensure that material integrity is maintained. In one example, material integrity may be associated with a minimum thickness in the base plate to support the heat removal surface extensions while performing heat removal for the computing component.

In a still further example, the deformation assembly may include one or more spacers used with a bonding material having a low melting point (e.g. indium tin) and one or more of a mechanical sub-system or the pressure-based sub-system. Altogether, these features support a controlled deformation applied to the cold plate by at least the spacers coupling to the cold plate for heat transfer. For instance, the spacers are thermally-conductive and are applied to a surface of the computing component in a pattern specific to the predetermined curvature. The spacers remain in place during the curing process ensuring a uniform bond-line thickness and preventing the bonding material from flowing out. The bonding material applied over the spacers, along with the mechanical sub-system or the pressure-based sub-system, allows the cold plate to deform and be bonded to the surface over the spacers.

The one or more spacers may allow control over a gap that may exist between the base plate and the computing component for the TIM. The control over the gap may be performed to prevent the TIM from being pushed out during use of the computing component or during preparation of the computing component for performing a workload. The one or more spacers may be an array of solder balls, micro bumps, or other thermally conductive material that may remain solid throughout a bonding process. In one example, the spacers may be placed between the computing component and the cold plate of a cold plate assembly and may be placed to ensure or allow a predetermined thickness for a bond-line. The one or more spacers to control the gap may not be of a specific shape (such as round) or a specific distribution (such as an array). The one or more spacers may be a quantity of structures of one or more of different shapes or different distributions. The spacers may be applied with limited forces and across relatively small surfaces in the gap to ensure least stress concentrations and damage to the computing component.

A metal solder TIM may be provided with the spacers and within the deformation assembly. The metal solder TIM may be provided as part of a cold plate and may be processed through a reflow oven as part of the pressure-based sub-system. As there may be no compression forces needed to deform the base plate, no stress may be imparted to the computing component from this process and, additionally, a TIM used with the cold plate assembly may not be displaced and may not be subject to any air bubbles generated therein that can impact heat transfer.

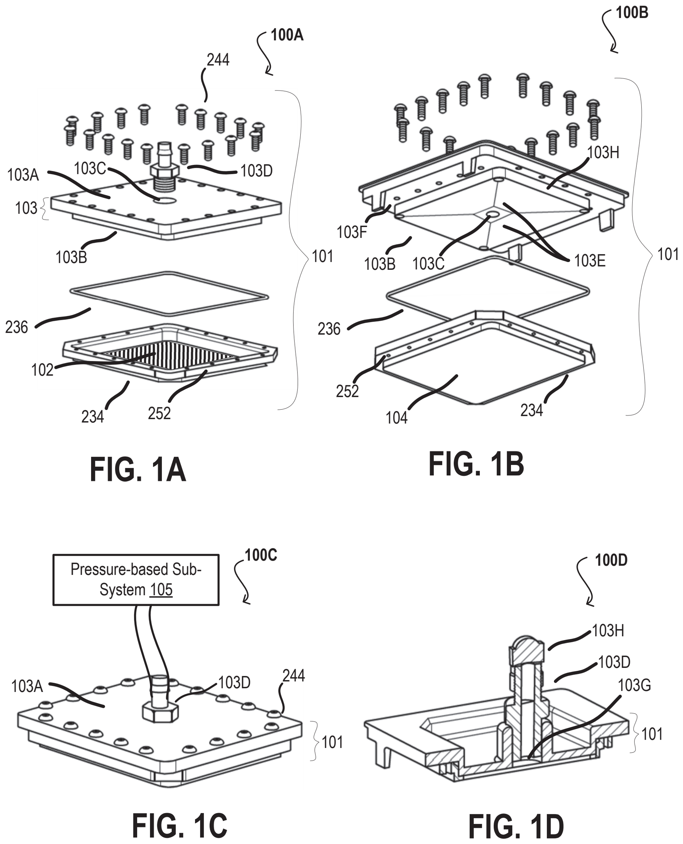

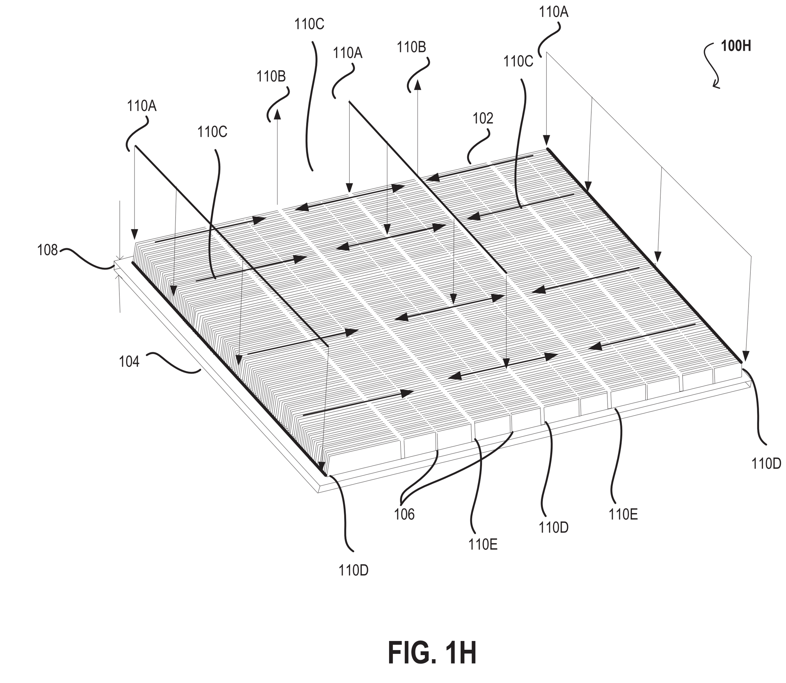

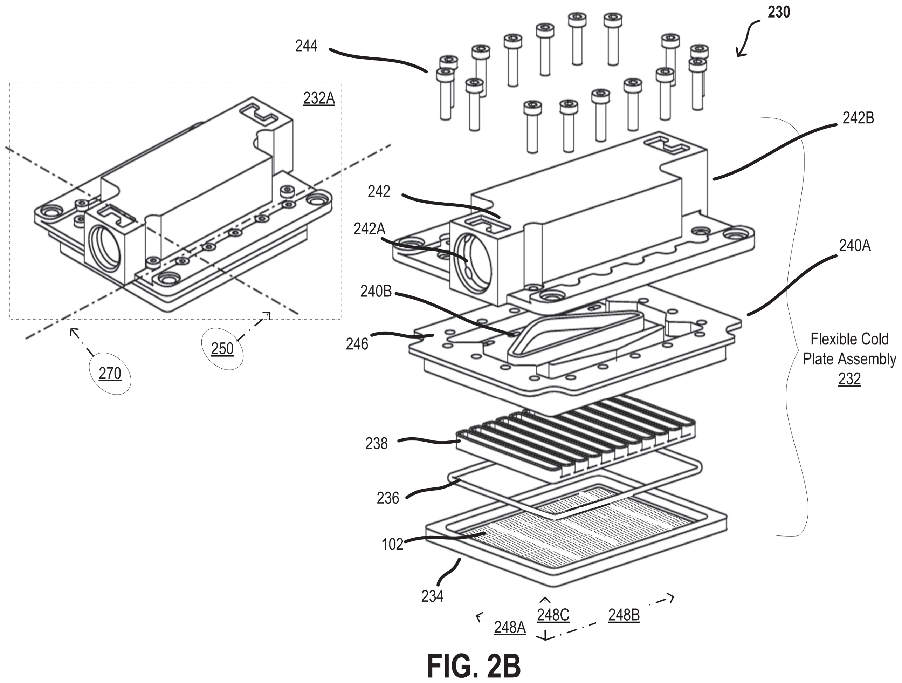

FIG. 1A is an exploded view 100A of a deformation assembly to support a cold plate assembly or to be part of the cold plate assembly, in at least one embodiment. In one example, the deformation assembly 101 may include a top plate 103A and a bottom plate 103B. In another example, the top plate 103A and the bottom plate 103B may be a single integrated plate 103. In one example, the deformation assembly 101 may be such that it is part of a cold plate assembly, such as a flexible cold plate assembly 232 (in FIG. 2B). The cold plate assembly may include a cold plate 234. The cold plate 234 may be a flexible cold plate, as described in connection with at least FIG. 1H. The deformation assembly 101, in another example, may be such that it supports a cold plate assembly by imparting the predetermined curvature to the cold plate 234, which may be removed and used in the cold plate assembly.

FIG. 1A also illustrates that there may be fasteners 244 used to hold together the deformation assembly 101, using apertures 103F (in FIG. 1B) through at least the top plate 103A. The apertures 103F may be provided to align with other apertures (such as of a cold plate assembly in FIG. 2B), to allow the cold plate 234 to be removed and used in a cold plate assembly 232. The cold plate 234 may include heat removal surface extensions, which are also described further in connection with at least FIG. 1H. The deformation assembly 101 may include an O-ring seal 236 which may be replaced if the cold plate 234 is to be removed and used with the cold plate assembly 232.

FIG. 1B is an exploded view 100B of a deformation assembly having a top plate and having a bottom profile with a predetermined curvature to allow a controlled deformation to a cold plate, in at least one embodiment. FIG. 1B illustrates that the bottom plate 103B may include a bottom profile 103E. The bottom profile 103E may include a predetermined curvature. The bottom plate 103B may be removably associated to the top plate 103A to support different bottom profiles 103E. In one example, the bottom plate may include different segments of different shapes to allow different bottom profiles 103E. FIGS. 1A, 1B also illustrates that an allowance 103C in the top plate 103A. The allowance 103C may be through the bottom plate 103B, as well. The allowance is for a valved connection port 103D associated with a pressure-based sub-system (such as in FIG. 1C) that may be associated to the allowance by threading or other coupling.

FIG. 1C is an assembled view 100C of a deformation assembly, with an allowance in the top plate for a pressure-based sub-system, in at least one embodiment. The valved connection port 103D may allow a pressure to be applied to an internal cavity, defined in part between the bottom profile 103E and other areas 103G (in FIG. 1D) at a top of the cold plate 234. The internal cavity may be generally referenced as belonging to the cold plate 234, in one example. The application of a pressure may occur from a pressure-based sub-system 105, through the valved connection port 103D, and may cause the base plate 104 of the cold plate 234 to controllably deform. For instance, based on a pressure and time associated with the application of a pressure, the controllable deformation may be achieved to a predetermined shape. The controllable deformation may be, in this example, based at least in part on the a pressure being applied and a shape of the bottom profile. In FIGS. 1A, 1B, 1C, the cold plate 234 is illustrated with elevated boundary areas 252, but the elevated boundary areas 252 may be provided only to support the deformation assembly 101, in at least one example.

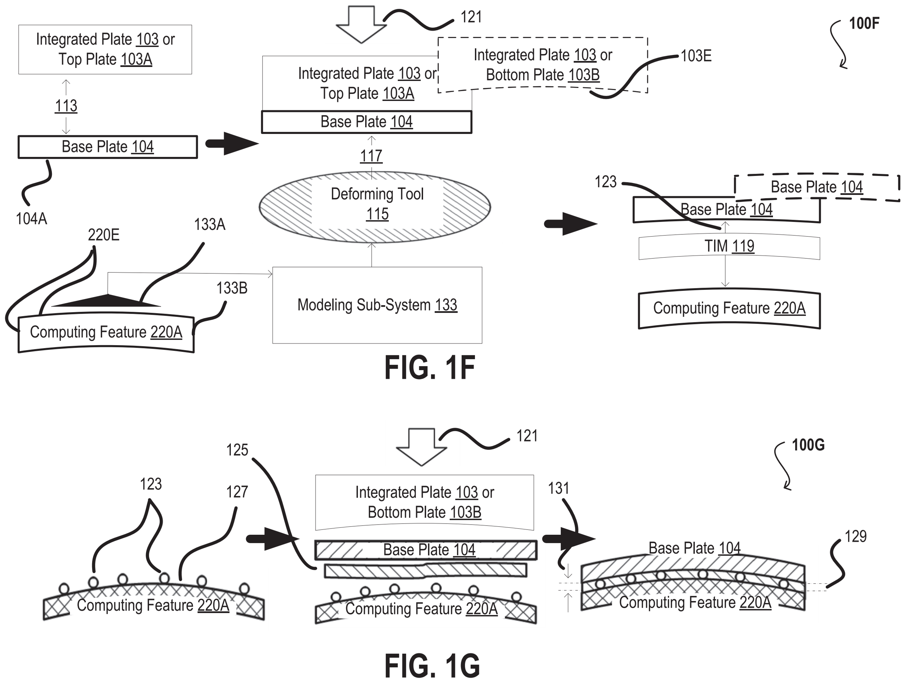

FIG. 1D is a cross-section view 100D of a deformation assembly, with a plug over the allowance in the top plate, in at least one embodiment. FIG. 1D illustrates that the pressure-based sub-system 105 may be used to provide a pressure through the allowance 103C, and may be plugged using a plug 103H so that the deformation assembly 101 as a whole may be used with the cold plate assembly 232. FIG. 1D also illustrates an additional dip 103I which may be part of the bottom profile 103E to provide a controlled deformation for both, a general shape throughout the base plate 104 and the bottom profile to the base plate 104. The use of the pressure-based sub-system to provide a pressure through the allowance 103C may represent the controlled deformation applied to the cold plate 234, in one example. Further, while discussed with respect to the cold plate 234, in any example herein, the controlled deformation may be caused to the base plate 104 (as illustrated in one or more of FIGS. 1F and 1G) and the heat removal surface extensions may be provided before or after the controlled deformation is performed.

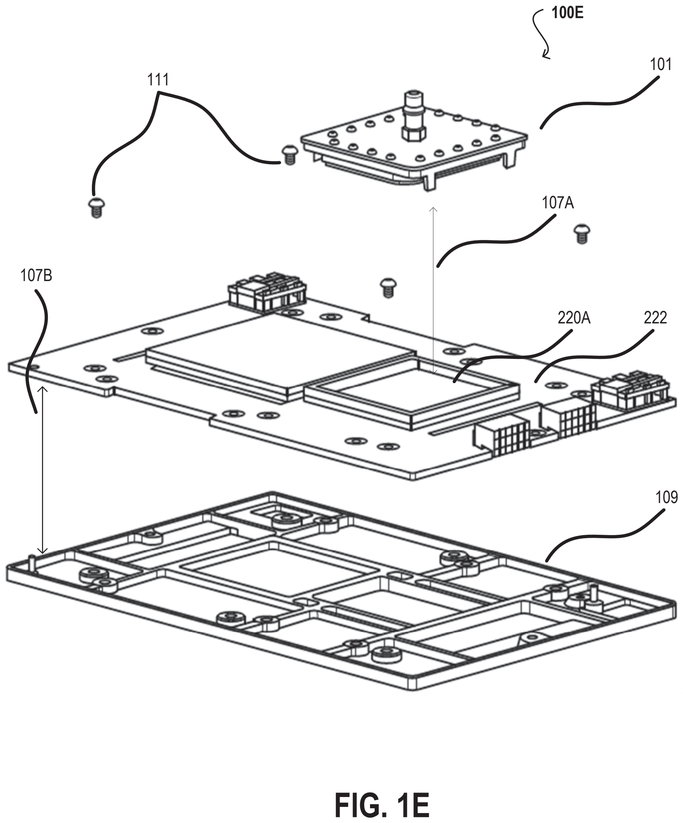

FIG. 1E is an exploded view 100E of a deformation assembly that is part of a cold plate assembly over a computing component, with a plug over the allowance in the top plate, in at least one embodiment. As illustrated, in one example, the pressure-based sub-system 105 may be used to provide a pressure (or sub-atmospheric pressure, relative to an external atmospheric pressure) to suction the cold plate 234 against the bottom profile 103E. This may cause the cold plate 234 to deform at least at its base plate 104. The top plate 103A and the cold plate 234 may remain or may be associated 107A with a computing component 220A when the computing component 220A is used to perform a workload.

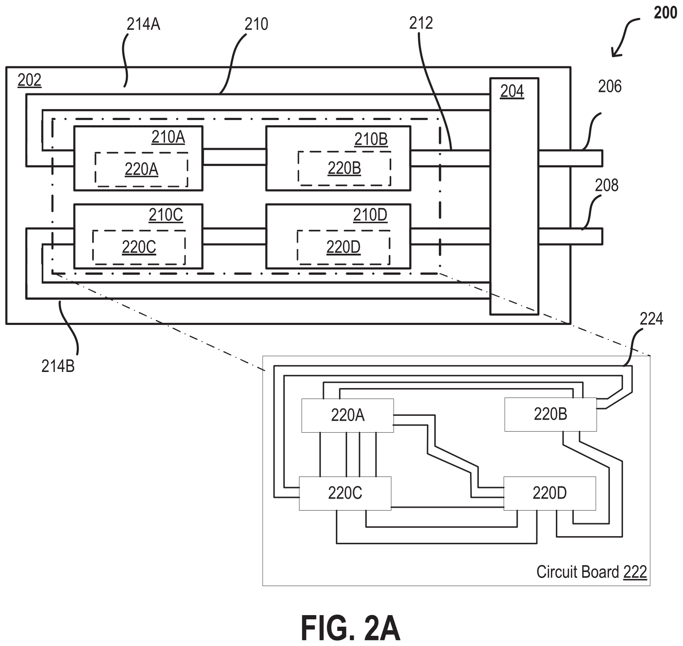

In at least FIGS. 1F and 1G, examples are provided of a base plate 104 of the cold plate 234 that may be removed from a deformation assembly 101 and that may be used in a cold plate assembly 232 with the computing component 220A. The deformation assembly 101 being part of the cold plate assembly 232 may provide additional benefits of, for example, allowing further and periodic pressure application to the sealed cavity 103E, 103G, through the valved connection port 103D of the pressure-based sub-system 105. FIG. 1E also illustrates that the computing component 220A may be on a circuit board 222 (also in FIG. 2A). FIG. 1E also illustrates that the circuit board may be coupled 107B to a rigid frame 109 using fasteners 111 provided through appropriate apertures of the circuit board 222 and of the rigid frame 109.

As a pressure applied may cause a lower or a higher pressure within the deformation assembly, relative to the external atmospheric pressure, the base plate 104 is allowed to controllably deform against the bottom profile of the deformation assembly. The base plate 104 is allowed to be used, once deformed, with a cold plate assembly 232. The base plate 104 may be a thin and flexible, as detailed in one or more of FIGS. 1H to 3C, to be able to accommodate the controllable deformation caused to it. The base plate has, thereon, heat removal surface extensions 102, which may be microchannels, in one example. The cold plate assembly 232 may have the top plate 103A that may be provided from a stiff structure. The stiff structure may be so that one or more of the top plate 103A or the bottom plate 103B does not deform under the pressures applied to allow the controlled deformation, when the top plate 103A and the bottom are used as part of the deformation assembly 101.

The inside surface of the bottom plate 103B or an integrated plate 103 may be machined to provide the bottom profile 103E having a predetermined curvature that may be an upward curvature. The bottom profile 103E may also be offset, from top features of the heat removal surface extensions 102, by a few hundred microns. This offset may allow the controlled deformation of the thin base plate 104 without any deformation to the heat removal surface extensions 102. The valved connection port 103D of the pressure-based sub-system 105 may allow the deformation assembly 101 to maintain the predetermined curvature for a computing component 220A. Once achieved, the deformation assembly 101 as a whole may be placed on top of a surface of the computing component 220A, as part of a cold plate assembly 232. In one example, there may be provisions in the cold plate assembly 232 to support the valved connection port 103D after it is plugged by a plug 103H. In another example, the plug 103H may be applied to the allowance 103C using a similar threading as the valved connection port 103D. As such, FIG. 1E illustrates that at least a portion of the deformation assembly 101 remains part of the cold plate assembly 232. For instance, all of the deformation assembly 101 may be used with the cold plate assembly 232, in one example. This may be after the controlled deformation of the cold plate and when the computing component is used to perform a workload.

FIG. 1F is an illustration of a process sequence 100F of a deformation assembly to associate with the cold plate and to allow a mechanical shaping at a bottom surface of a base plate of the cold plate to allow a predetermined curvature for the cold plate, in at least one embodiment. For example, as described in connection with one or more of FIGS. 1A-1E, an integrated plate 103 or a top plate 103A may be used in the process sequence 100F. The integrated plate 103 or the top plate 103A may be used interchangeably used in the examples herein, unless otherwise stated. The integrated plate 103 or the top plate 103A may be associated 113 with the cold plate 234 at the base plate 104. In one example, the integrated plate 103 or the top plate 103A may be associated 113 to the base plate 104 alone and aspects of the cold plate 234, including the elevated boundary areas 252, may be provided after the controlled deformation of the base plate 104. The association 113 of the integrated plate 103 or the top plate 103A to the cold plate 234 or the base plate 104 may be to allow a mechanical shaping 117 to be performed at a bottom surface 104A of the base plate 104.

The mechanical shaping 117 may be a machining performed to a bottom surface 104A of the base plate 104, as part of the controlled deformation applied. The mechanical shaping 117 may be performed by a physical cutting or other deforming applied to only the bottom surface of the cold plate, before the cold plate 104 is removed and is applied to the computing component 220A as part of the cold plate assembly. There may be no pressure used in this example, relative to the examples in FIGS. 1A-1E. In the process sequence 100F of FIG. 1G, a non-flat surface may be created for at least the bottom surface 104A of the base plate 104, through the machining process, with or without the base plate being entirely deformed. While the thin and flexible base plate 104 may have sufficient material, the machining may be performed by controlling the process to ensure that material integrity is maintained. In one example, material integrity may be associated with a minimum thickness in the base plate 104 to support the heat removal surface extensions 102 while performing heat removal for the computing component 220A.

The mechanical shaping 117 may leave a top surface of the base plate 104, which may include or which may be to include the heat removal surface extensions 102, intact and without deformation (as in the solid line illustration of the base plate 104 over the TIM 119 in FIG. 1F). The mechanical shaping 117 may be formed with a deforming tool 115 to provide the controlled deformation applied to the cold plate 104. The deforming tool 115 may be a mechanical cutter or slicer for metal materials and may be part of a deformation sub-system. The mechanical shaping 117, performed by the deforming tool 115, may be to physically cut or slice to deform only the bottom surface 104A of the base plate 104 to the predetermined curvature of the computing component 220A. The mechanical shaping 117 may be performed along with a force 121 applied to the base plate 104, opposite to the deforming tool 115, to ensure that the mechanical shaping 117 occurs to intended areas, for instance. The process sequence 100F may include removing the base plate 104 from the association with the integrated plate 103 or the top plate 103A. The process sequence 100F may include associating the base plate 104 to the computing component 220A, with a TIM 119 applied therebetween. While illustrated as a prominent layer, the TIM 119 may be a layer of microns in thickness. While illustrated as prominent deformations in the base plate 104 and the computing component 220A, the deformations may not be as visible without optical and other non-visual measures being performed.

In one example, the deforming tool 115 may be supported by a modeling sub-system 133. The modeling sub-system 133 may include at least one processor and memory having instructions that, when executed by the at least one processor, causes the modeling sub-system 133 to generate or provide the predetermined curvature to be imparted to a base plate 104. The predetermined curvature may be generated or provided based in part on input that may be a surface modeling or other (such as sidewall) modelling 133A, 133B of a curvature 220E of the computing component 220A. Although illustrated as a convex surface curvature, there may be multiple continuous or broken, convex or concave, or regular or irregular deformations that define the curvature 220E. The at least one processor and memory may be as discussed herein. In addition, the surface modeling may be based in part on a scan of a topography of the computing component 220A. While discussed with respect to the deforming tool 115, the modeling sub-system 133 may be provided similarly for the pressure-based sub-system 105 and/or for allowing a bottom profile 103E to be provided for the integrated plate 103, the top plate 103A, or the bottom plate 103B. In addition, the pressure-based sub-system 105 may allow the bottom profile 103E to include a sidewall profile to be provided for the integrated plate 103, the top plate 103A, or the bottom plate 103B. In one example, as such, the pressure-based sub-system 105 may allow positive or negative pressure to be applied to the bottom profile 103E and the sidewalls 103H in the deformation assembly 101.

In process sequence 100F, instead of a top plate 103A, a bottom plate 103B or an integrated plate 103 may be used such that the bottom plate 103B or the integrated plate 103 has a bottom profile 103E associated with the predetermined curvature of the computing component 220A. The bottom profile 103E may be to allow a mechanical shaping at the bottom surface of the base plate 104 of the cold plate 234. The mechanical shaping may be performed by pressure (from at least the applied force 121) between the base plate 104 and the bottom plate 103B or the integrated plate 103. The pressure may cause the controlled deformation to be provided to only the bottom surface 104A of the base plate 104, based at least in part on the bottom profile 103E of the bottom plate 103B or the integrated plate 103 (as in the broken line illustration of the base plate 104 over the TIM 119 in FIG. 1F). The base plate 104 may be removed from the deformation assembly 101 having the bottom plate 103B or the integrated plate 103, and may be used with a cold plate assembly 232, the TIM 119, and the computing component 220A.

Therefore, in the process sequence 100F, the deformation assembly 101 may be distinct from the cold plate assembly 232. This may be at least because the cold plate 232 or the base plate 104 may be removed from the deformation assembly 101 having the bottom plate 103B or the integrated plate 103 and no part of the deformation assembly 101 may be used in the cold plate assembly 232. Only the cold plate 232 or the base plate 104 may be provided for the cold plate assembly 232, in one example. The deformation assembly 101 may be included on a mechanical sub-system that may form the deforming tool 115, in one example. The mechanical sub-system may only apply or support force 121 application between the base plate 104 and the bottom plate 103B or the integrated plate 103. This may be different from any cutting or slicing otherwise available in other examples.

The bottom plate 103B or the integrated plate 103 having the bottom profile 103E may be used with the mechanical sub-system to support a mechanically applied force 121 or load, as the controlled deformation, to cause the cold plate 104 to deform to the bottom profile 103E of the bottom plate 103B or the integrated plate 103. The mechanical sub-system can plastically deform the base plate 104 through the mechanically applied force 121 or load, prior to installation on the computing component 220A. In this example, the mechanically applied force 121 or load may need to be monitored to ensure that the base plate 104 and the heat removal surface extensions 102, if already on the base plate 104, are not pushed and/or deformed beyond operating deflections allowable (such as by predetermined deflection range to support heat removal) to achieve predetermined deformation.

FIG. 1G is another illustration of a process sequence 100G of a deformation assembly to include one or more spacers, a bonding material, and an allowance for one or more of a mechanical sub-system or a pressure-based sub-system to allow a predetermined curvature for a cold plate, in at least one embodiment. In this process sequence 100G, the deformation assembly 101 having the bottom plate 103B or the integrated plate 103 may include one or more spacers 123 used with a bonding material 125 and with one or more of a mechanical sub-system or the pressure-based sub-system. The bonding material 125 may be a TIM 119, as described with respect to one or more of FIGS. 1A-1F, and may include bonding properties. Altogether, these features support a controlled deformation applied to the cold plate 234 by at least the spacers 123 coupling to the base plate 104 of the cold plate 234 for heat transfer. For instance, the spacers 123 are thermally-conductive and are applied to the surface 127 of the computing component in a pattern specific to the predetermined curvature, as illustrated. The bonding material 125, may be applied over the spacers 123, along with the mechanical sub-system or the pressure-based sub-system, represented in part by the bottom plate 103B or the integrated plate 103. This allows the base plate 104 of the cold plate 234 to deform and be bonded to the surface 127 over the spacers 123.

The one or more spacers 123 may allow control over a gap 129 that may exist between the base plate 104 and the computing component 220A for the TIM. The control over the gap 129 may be performed to prevent the TIM or bonding material 125 from being pushed out during use of the computing component 220A or during preparation of the computing component 220A for performing a workload. The one or more spacers 123 may be an array of solder balls, micro bumps, or other thermally conductive material that may remain solid throughout a bonding process. In one example, the spacers 123 may be placed between the computing component 220A and the cold plate 104 of a cold plate assembly 232 and may be placed to ensure or allow a predetermined thickness 131 for a bond-line, as illustrated in at least FIG. 1G. The one or more spacers 123 may control the gap 129 and may not be of a specific shape (such as round) or a specific distribution (such as an array). The one or more spacers 123 may be a quantity of structures of one or more of different shapes or different distributions. The spacers 123 may be applied with limited forces and across relatively small surfaces in the gap 129 to ensure least stress concentrations and damage to the computing component. In one example, the spacers 123 may be applied by embedding the spacers within a solder, as part of the process sequence 100G herein.

The process sequence 100G illustrates that a metal solder TIM may be a bonding material 125 that may be provided with the spacers 123 within the deformation assembly 101. The metal solder TIM may be provided as part of a cold plate 234 and may be processed through a reflow oven as part of the pressure-based sub-system 105. As there may be no compression forces needed to deform the base plate 104, no stress may be imparted to the computing component 220A from this process and, additionally, a TIM used with the cold plate assembly 232 may not be displaced and may not be subject to any air bubbles generated therein.

The examples herein may address computing components, including graphics processing units (GPUs), which have become larger in dimension and which may have a warpage associated with them. When a computing component is at room temperature, the computing component may be at its most warped stage. When the computing component is at operating temperature, the computing component may be at its least warped stage. Heatsinks and other cooling plates may be designed to be flat and stiff structures and may not conform to the changing warpage. This may cause issues with TIMs when such flat and stiff structures are attached to a non-flat silicon die surface that may be in at least one computing component. The examples herein may use a flexible copper base plate in a cold plate, different than the flat and stiff structures. The flexibility in the flexible cold plate allows surfaces of a base plate in the flexible cold plate to conform and match changing warpage of a computing component. In addition, in at least one example, it is possible to create a controllably deformed surface at the bottom 104A of the cold plate 234 to match a curvature or warpage associated with the computing component before it is used to perform a workload. A modeling, as described herein, may be performed to provide a bottom profile 103E for a deformation assembly and may result in the ability to have a thin and uniform bond line to achieve a lowest temperature of rise and repeatable performance for cooling in a computing component. In another example, the modeling may include sidewalls of the computing component or feature 220A.

In an example, POR (Polystyrene, Oligomer Rubber) may be a type of TIM that may be used with a computing component. The POR TIM may be grease-based. The POR TIM may be subject to TIM pump-out. TIM pump-out may be caused by a mismatch in a coefficient of thermal expansion (CTE) between the cold plates (which may have a CTE of about 17 ppm/C) and silicon of a computing component (which may have a CTE of 2 - 3 ppm/C). The mismatch may allow relative motions of the cold plate and computing component as the cold plate assembly heats up and cools down when performing a workload, for instance. This may cause the TIM to pump out of the gap 129 between surfaces of the cold plate and the computing component. This may cause difficulties in controlling a bond-line thickness, which may be a thickness of the TIM between the cold plate and the computing component. Metal solder TIMs, differently, may be displaced during a bonding process, when pressure is applied from the cold plate down through the computing component. There may be movement of material resulting in air voids, which may cause performance issues and unpredictable behaviors.

All such issues may be addressed by the cold plates herein having controlled deformation applied thereto. For example, controllably deforming a bottom surface 104A of the cold plate 234 prior to mounting it to a bare die silicon of a computing component, followed by a metal solder TIM process may allow reduction in forces applied to the TIM or within the gap having the TIM, between the cold plate and the bare die silicon. This may prevent the solder displacement and may allow the metal solder TIM to stay in place as the metal solder TIM may require a melted/liquid form during bonding installation or application. The bond-line resulting therefrom may be uniform and fixed throughout the bonding installation or application, and may prevent air bubble inclusions. To do so, the pressure-based approach in at least FIGS. 1A-1E may allow a cold plate cavity to incorporate or transfer forces from an external environmental (as part of an air-pressure controlled deformation performed. The pressure-based approach in one or more of FIGS. 1F, 1G may be used with or separate from the pressure-based approach, where a copper base plate (e.g., pedestal) 104 may be made into a convex controllably deformed bottom surface 104A prior to a soldering process involving a metal solder TIM. There may be plastic controllable deformation of material of the base plate 104, which may create an intended bottom profile (such as a concave profile), without added stress risks to the silicon of the computing component. A machine-based approach in one or more of FIGS. 1A-1G may be used with or separate from the pressure-based approach and the pressure-based approach, and may allow machining of the bottom surface 104A of the cold plate 234 with a curvature of the computing component. In addition, the thermally conductive spacers, which may be micro-bumps of a pre-determined height, may ensure a uniform bond-line, as described with respect to at least FIG. 1G.

As package sizes of cold plates have been increasing and may be subject to limitations in dimensions relative to a computer module. The increase in package sizes may cause issues, such as warping, in certain applications. Further, warping in a cold plate may result in gaps between a cold plate and an underlying computing components or features. Consequently, the gaps may cause an uneven thermal connection between the cold plate and the computing component at any interface there between. Further, there may be stresses on brittle silicon and on solder joints of a ball grid array (BGA) of a circuit board supporting such solder joints. The stresses may be from handling of the cold plate and its attachment forces and during servicing events associated with lidless or exposed packages of the computing components. In addition, a lidless cold plate may be subject to an issue of deflection under pressure from fluid flow.

A flexible cold plate assembly, as described herein may allow improved contact and heat removal from an underlying computing component that may warp due to heat and other factors during performance of a workload. The flexible cold plate assembly may include a flexible cold plate formed of one or more of a thin base plate or heat removal surface extensions having discontinuities (such as crosscuts on fins or microchannels of the cold plate allow flexing, as part of the controlled deformation, of the cold plate along with or separately from the thin base plate). There may be seals and other components within the flexible cold plate assembly to direct fluid used with the heat removal surface extensions. Further, when a thin base plate is used, the combination, along with the heat removal surface extensions, may allow, in part, the flexible cold plate to be further conforming or flexing, as part of the controlled deformation and with respect to warping in the underlying computing component.

FIG. 1H is an illustration of a flexible cold plate 100H having heat removal surface extensions, discontinuities within the heat removal surface extensions, or one or more thin base plate, in at least one embodiment. The flexible cold plate 100H may be used with the deformation assembly 101 to receive controlled deformation, to match a curvature of a computing component 220A and to support a uniform thermal bond-line. The flexible cold plate 100H may be part of a cold plate assembly 232 (as in FIG. 2B) that may be a flexible cold plate assembly and may allow for conformance or flexing to support controlled deformation associated with an underlying computing component, as detailed further in connection with FIGS. 2B-5C. The controlled deformation may require conformance or flexing in the cold plate 234 and may be based, at least in part, on heat removal surface extensions 102 provided on a base plate 104 and having one or more of discontinuities 106 within the heat removal surface extensions 102 or a base plate 104 being thin.

The heat removal surface extensions 102 may be structures with heat removal channels there between. The heat removal channels may be for fluid or other media to enter from the cold plate distribution channels, to flow through, and to exit the heat removal channels to other cold plate distribution channels provided. For example, a flow of fluid or other media may enter 110A evenly across multiple ones of the cold plate distribution channels that may be inlet channels 110D. The inlet channels 110D may be a center channel and outer edge channels of the cold plate distribution channels, as illustrated. The flow may occur through the heat removal channels 110C (which may be microchannels that may not be fully illustrated and may not be to scale in FIG. 1H). The flow may exit 110B out of multiple ones of the cold plate distribution channels that may be outlet or exit channels 110E of the cold plate distribution channels, as illustrated. Further, FIG. 1H illustrates that flow through the heat removal channels 110C may be an even or uniform flow. FIG. 1H does not illustrate every inlet channels 110D, every outlet or exit channel 110E, every entry 110A flow, every exit 110B flow, or every heat removal channel 110C, but these are readily apparent to address cooling needs, and can be scaled up or down (more or less channels, entries, and exists), as required. The discontinuities 106 may be cross-cuts on fins, in one example. The controlled deformation to cause conformance or flexing may be based, at least in part, on the base plate 104 being thin.

In another example, the flexible cold plate assembly (such as in FIG. 2B) may include the flexible cold plate 100H which allows for conformance or flexing to support warping and controlled deformation associated with an underlying computing component (such as illustrated computing component 220A). The conformance or flexing may be based, at least in part, on controlled deformation, on heat removal surface extensions 102 provided over a base plate 104 having a dimension or thickness 108 of between 150 microns and 500 microns, and may be additionally based, at least in part, on the heat removal surface extensions having discontinuities 106 therein. The discontinuities may be perpendicular to a direction of the entry 110A flow and exit 110B flow, with respect to fluid or other media used for cooling the underlying computing component, through the heat removal surface extensions 102.

A flexible cold plate 100H may include a thin base plate 104 formed of copper or other suitable heat removal or transfer material, which may be also used for the heat removal surface extensions 102. As used herein, the heat removal surface extensions 102 may be provided of a same material or a different material, relative to the base plate 104, and may extend a surface area of the base plate 104 that is subject to heat removal. Therefore, the heat removal surface extensions 102 may be fins, including cylindrical fins, square fins, and other dimensional fins, or may include a roughness or other textured surface. When the heat removal surface extensions are fins, they may provide there between heat removal channels representing heat removal surface extensions, in at least one embodiment.

Further, the thin base plate herein may allow, in part, the flexible cold plate to be conformal or flexible as part of the controlled deformation. In one example, the flexible cold plate herein may be able to follow a dynamic curvature of an underlying computing component throughout its lifecycle (including both during usage and preparation stages) and provide tolerance control. In one example, the flexible cold plate flexes with the changing component warpage as the component increases or decreases in warpage during cooling and heating cycles. The underlying computing component may be in reference to a circuit board, a central processing unit (CPU), a graphics processing unit (GPU), a data processing unit (DPU), quantum processing units (QPUs), a plurality of parallel processing units (PPUs), or other such component that may have active parts and passive or less active parts, where the passive or less active parts may be associated with a lower activity measure relative to at least one active part. For instance, a core of the GPU may be an active part, whereas buffer regions of the component may be a passive or less active part for the GPU.

QPUs may be configured to perform one or more operations associated with a quantum algorithm. In some embodiments, each of the one or more QPUs may include a plurality of qubits and the one or more QPUs may be in communication with each other via a quantum channel. In some embodiments, each of the plurality of qubits may include local qubits, global qubits, and/or synchronization qubits. In some embodiments, the local qubits of each QPU may be configured to perform the one or more operations associated with the quantum algorithm on the QPU, with which the local qubits are associated.

As the underlying computing component is subject to heating or cooling during or after performing of a workload, there may be a possibility for warping or the curvature to occur in a nonuniform manner. In addition to the base plate being thin, the flexible cold plate assembly may include the discontinuities within the heat removal surface extensions 102 to allow a degree of stress relief for the flexible cold plate assembly. The flexible cold plate assembly may also include a distribution seal (FIGS. 2B-3C). The distribution seal may have flexing or conformance properties and may include a material such as rubber (including ethylene propylene diene monomer rubber), silicone, or other suitable material (including elastomers) to allow a seal between the flexible cold plate and an overlying distribution manifold. The distribution seal may provide a sealing surface on the top of the heat removal surface extensions while allowing the heat removal surface extensions and the heat removal surface extensions to flex. In one example, a bottom side of the distribution seal may have a flat surface to sit flush and to provide a sealing surface on top of the heat removal surface extensions, as well as the discontinuities. At the same time, the flat surface allows fluid through intended paths of the heat removal surface extensions, without exiting the flexible cold plate, while supporting further conforming or flexing of the base plate in the flexible cold plate assembly.

In one instance, the flexible cold plate assembly may support a fluid or other media, such as a coolant, through a flow path formed from a manifold lid, a distribution manifold, a distribution seal, and the heat removal surface extensions. The heat removal surface extensions may be implemented using a manifold microchannel (MMC) approach that is apparent upon fully reviewing the disclosure herein. In operation, a fluid may enter the heat removal surface extensions vertically, from ports of a manifold lid to a distribution manifold and to the distribution seal (detailed further in FIGS. 2B-3C). The fluid may impinge on the base plate 104 of the heat removal surface extensions 102, may be caused to turn 90 degrees, and may be caused to travel along each of the heat removal surface extensions 102. The fluid may then turn another 90 degrees and may exit vertically from the heat removal surface extensions 102 of the flexible cold plate 100H, through the distribution seal, the distribution manifold, and the distribution lid, to exit the flexible cold plate assembly.

A cross-section view and plan view of the flow path, the heat removal surface extensions 102 and the discontinuities 106 are detailed in the figures herein. The discontinuities 106 may be interspersed between inlet and outlet aspects of the heat removal surface extensions 102. The discontinuities 106, in addition to providing stress relief, may also break up a momentum and a thermal boundary layer of a flexible cold plate. This may support or lead to enhanced thermal performance in the flexible cold plate assembly. The distribution seal may be a flexible gasket or seal that can, in addition to providing a first seal for tops of the heat removal surface extensions using a flat bottom side, provide a second seal which is around vertical members or features forming manifold distribution channels in the distribution manifold using U-shaped features on a top side of the distribution seal. The second seal is to prevent fluid from crossing between inlet and outlet ports of the distribution manifold.

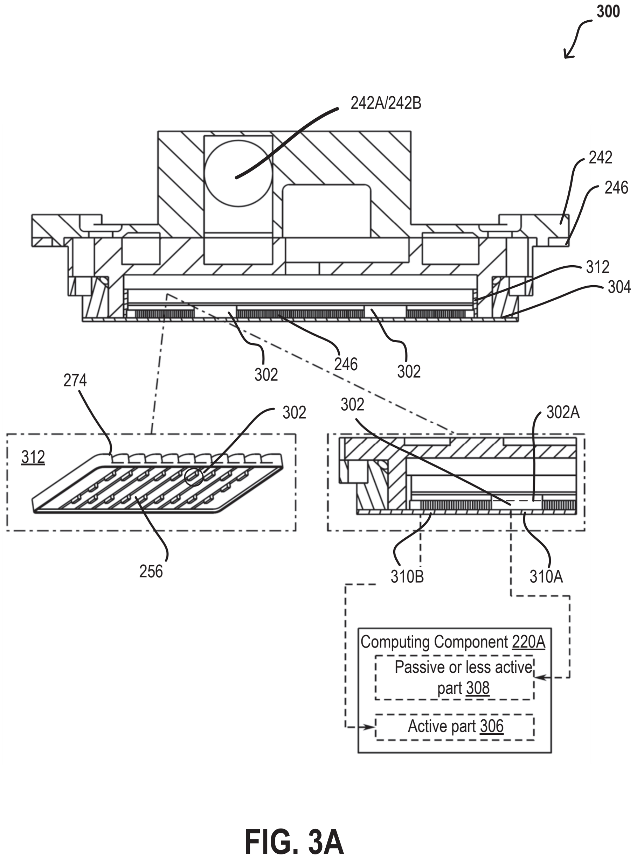

The second seal can prevent flow exchange (such as leakage) between inlet and outlet ports of the distribution manifold, in a similar manner as the first seal at the top of the heat removal surface extensions prevents fluid from crossing individual ones of the heat removal surface extensions. In addition, the distribution seal can flex with the underlying computing component while maintaining the seal at its top and bottom sides. Another aspect of the flexible cold plate assembly herein is an ability to restrict flow to less active parts of the underlying computing component using, at least in part, the distribution seal, as detailed with respect to at least FIG. 3A herein. For instance, the distribution seal may include the flow restrictors, which may be strategically located in between the heat removal surface extensions. Their placement may be predetermined based at least in part on layouts associated with the underlying computing component being cooled. The flexible cold plate assembly having such a distribution seal can prevent fluid from traveling over parts of a base plate of the flexible cold plate that are located over a passive or less active part of the underlying computing component. Still further, the flexible cold plate assembly herein may rely on a dual-plate distribution seal with a spring, such as a wave spring. The spring allows application of pressure on at least one plate that is movable, in relation to another plate that is stationary, and allows the dual-plate distribution seal to maintain at least the seal with respect to the tops of the heat removal surface extensions.

The flexible cold plate assembly herein can address component sizes that are increasing and that have large package sizes. A result of a large package size may be warpage of the package during use or when cooling of the component. The flexible cold plate assembly herein may be used in components that include liquid-cooled products in a server tray, a server rack, or other aspects of a datacenter, as described in connection with at least FIG. 1B. Instead of rigid and inflexible cold plates that may have a thickness of 1.25 millimeter or more, the flexible cold plate assembly herein is able to address warpage and provide further benefits of improved performance of the underlying computing component using one or more of a thin base plate, discontinuities, and a distribution seal capable of conforming or flexing. A consequence of rigid and inflexible cold plates may be that when such a cold plate is placed on top of a bare GPU die, forming a representative component to be cooled, such a cold plate may be high-centered and may have a minimal bond-line thickness at an apex of the component. Such a rigid and inflexible cold plate may also have a greater bond-line thickness at the edges of the component.

Warpage in a component and its associated package may change with operating temperature, where the package may be most warped at room temperature and may be least warped at operating temperature. A difference between a flattest and a most warped state may be measured in the range of several hundred microns. However, warpage may result in changing bond-lines, which can make thermal interface material (TIM) management challenging. Another challenge addressed by the flexible cold plate assembly herein is an issue posed by rapidly rising power consumption of a component, such as a GPU. The combination of increasing package sizes, increasing warpage, and increasing power consumption can be addressed by a high-performance copper-based flexible cold plate within the flexible cold plate assembly. The flexible cold plate assembly may be able to conform with the changing component warpage and may provide a high-performance bond whose integrity is maintained by the component warpage changes during operation.

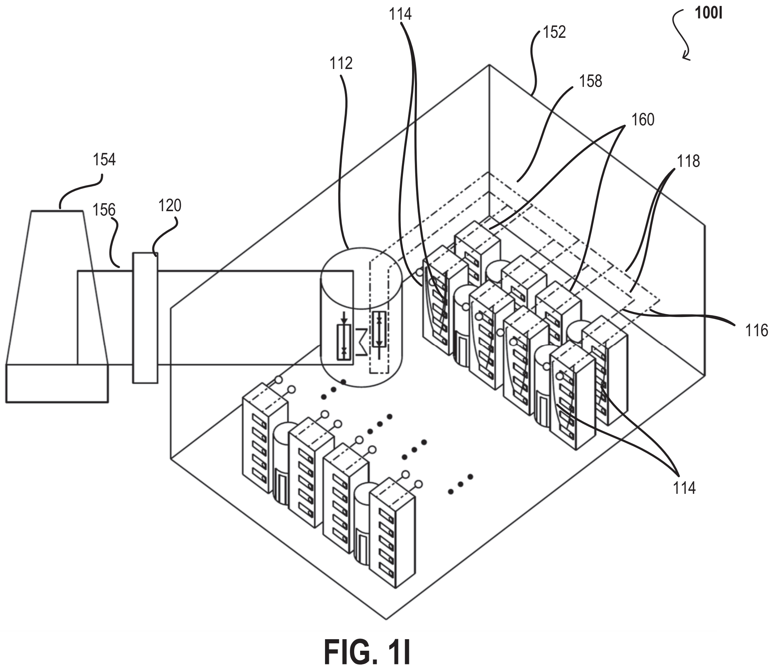

FIG. 1I is an illustration of a datacenter 100I subject to a flexible cold plate assembly, in at least one embodiment. The datacenter 100I may be subject to a flexible cold plate assembly having heat removal surface extensions and discontinuities that are perpendicular to a direction of flow of a fluid through the heat removal surface extensions, as described in connection with FIG. 1H, along with distribution seals that support the flexible cold plate assembly, as described in connection with one or more of FIGS. 2A-3C. The datacenter 100I may be one or more rooms 152 having racks 160 and auxiliary equipment to house one or more servers on one or more server trays having circuit boards therein, which may be altogether referred to herein as computer modules. The datacenter 100I may be supported by a cooling tower 154 located external to the datacenter 100I. The cooling tower 154 may dissipate heat from within the datacenter 100I by acting on a primary cooling loop 156. Further, a cooling distribution unit (CDU) 112 may be used between the primary cooling loop 156 and a secondary cooling loop 158 to allow extraction of the heat from the secondary cooling loop 158 to the primary cooling loop 156. The secondary cooling loop 158 can access various plumbing all the way into the server tray as required, in an aspect.

The primary and secondary cooling loops 156, 158 are illustrated as line drawings, but a person of ordinary skill would recognize that one or more plumbing features may be used. In an instance, flexible polyvinyl chloride (PVC) pipes may be used along with associated plumbing to move the media along in each of the primary and secondary cooling loops 156, 158. One or more pumps, in at least one embodiment, may be used to maintain pressure differences within the primary and secondary cooling loops 156, 158 to allow the movement of a media (such as a primary media or a secondary media that may be a coolant or refrigerant) according to temperature sensors in various locations, including in the room, in one or more racks 160, and/or in server boxes or server trays within the racks 160. As used herein, at least the secondary cooling loop 158, which is associated with a primary cooling loop 156, may be configured to cool computing components of the computer module using a flexible cold plate assembly having a distribution manifold with central fasteners and a stiffener frame with perimeter fasteners, as detailed further in one or more of FIGS. 2A-7 herein.

In at least one embodiment, a secondary media in a secondary cooling loop 158 have an inlet temperature of above 0 degrees centigrade (°C) but less than 40 °C, and may exit with a temperature of about 60 °C. In one example, a primary media in the primary cooling loop 156 may be used to cool the secondary media in the secondary cooling loop 158. The primary media and the secondary media may be at least water and an additive, for instance, glycol or propylene glycol. In operation, each of the primary and the secondary cooling loops 156, 158 have their own media. In an aspect, the media in the secondary cooling loops may be proprietary to the requirements of the components in the server tray or racks 160.

The CDU 112 may be capable of sophisticated control of the primary and the secondary media, independently or concurrently, in the primary and the secondary cooling loops 156, 158. For instance, the CDU 112 may be adapted to control the flow rate of a secondary media of the secondary cooling loop 158 so that the secondary media may be appropriately distributed to extract heat generated within the racks 160. Further, more flexible rack manifold or tubing 114 is provided from the secondary cooling loop 158, relative to the primary cooling loop, to allow entry to each computer module and to provide secondary media to the computing components therein. In the present disclosure, the computing components may be used interchangeably to refer to the heat-generating components that benefit from the present datacenter cooling system.

The room manifold or tubing 118 illustrated in FIG. 1B and that may form part of the secondary cooling loop 158 may be referred to as room manifolds or room tubing. Separately, additional row manifold or tubing 116 extending from such room manifolds or tubing 118 may also be part of the secondary cooling loop 158 but may be referred to as row manifolds or row tubing. Still further, the rack manifold or tubing 114 illustrated in FIG. 1B may enter the racks as part of the secondary cooling loop 158, but may be referred to as rack cooling manifold. Further, the row manifolds or tubing 116 may extend to all racks along a row in the datacenter 100I. The plumbing of the secondary cooling loop 158, including the room, row, or rack manifolds or tubing 118, 116, and 114 may be improved by at least one embodiment of the present disclosure. An optional chiller 120 may be provided in the primary cooling loop within datacenter 100I to support cooling before the cooling tower. To the extent additional loops exist in the primary control loop, a person of ordinary skill would recognize reading the present disclosure that the additional loops provide cooling external to the rack and external to the secondary cooling loop; and may be taken together with the primary cooling loop for this disclosure.

In at least one embodiment, in operation, heat generated within server trays of the racks 160 may be transferred from at least one cold plate to a media exiting the racks 160 via flexible tubing of the rack manifold or tubing 114 of the secondary cooling loop 158. In one example, secondary media (in the secondary cooling loop 158) from the CDU 112, for cooling the racks 160, moves towards the racks 160. The secondary media from the CDU 112 passes from one side of the room manifold or tubing 118, to one side of the rack 160 via row manifold or tubing 116, and through one side of the server tray via provided rack manifold or tubing 114. Spent secondary media (or exiting secondary media carrying the heat from the computing components) may exit out of another side of the server tray (such as entering the left side of the rack and exiting the right side of the rack for the server tray after looping through the server tray or through components on the server tray). The spent secondary media that exits the server tray or the rack 160 comes out of different side (such as exiting side) of rack manifold or tubing 114 and moves parallel, but also exiting side, row manifold or tubing 116. From the row manifold or tubing 116, the spent secondary media may move in a parallel portion of the room manifold or tubing 118 going in the opposite direction than the incoming secondary media (which may also be the renewed secondary media), and towards the CDU 112. Further, the spent secondary media may have an exit temperature of above 0 °C and may specifically be in a range which is between 40-60 °C.

In at least one embodiment, the spent secondary media may exchange its heat with a primary media in the primary cooling loop 156 via the CDU 112. The spent secondary media may be renewed (such as relatively cooled when compared to the temperature at the spent second coolant stage) and ready to be cycled back through the secondary cooling loop 158 to the computing components or features. Various flow and temperature control features in the CDU 112 allow control of the heat exchanged from the spent secondary media or the flow of the secondary media in and out of the CDU 112. The CDU 112 is also able to control a flow of the primary media in primary cooling loop 156.

FIG. 2A is an illustration of computer module aspects 200 of a flexible cold plate assembly, in at least one embodiment. The computer module aspects 200 may include server-level features and may include a computer module 202 having at least one server manifold 204 to allow entry and egress of a cooling media of a secondary cooling loop 158, from a rack 160. However, the server manifold 204 may include separate channels for an inlet and for exit of media of the secondary cooling loop 158, which is illustrated as an extension from the rack to be secondary cooling loops 214A, 214B, within the computer module.

The secondary media may enter from a rack manifold, via inlet pipe 206 and may exit via outlet pipe 208. The secondary media, on the server side, may travel via inlet line 210, through one or more cold plates 210A, 210B, and via outlet line 212 to the manifold 204. This represents at least one or multiple secondary cooling loops 214A, 214B within the computer module 202 that may have a server tray or box form-factor. These multiple secondary cooling loops 214A, 214B may be an extension of the secondary cooling loop 158 interfacing with the primary cooling loop 156 as they provide the same or substantially the same secondary media from the secondary cooling loop 158 to the cold plates 210A-210D. In at least one embodiment, the cold plates 210A-210D are associated with at least one computing component or feature 220A-220D. In addition, while illustrated as different cold plates, the illustrated cold plates 210A-210D may be part of a large single cold plate structure and have integrated contact points that are specifically over the underlying computing components 220A-220D. A computing component 220A-220D may include processors, memories, and switches or regulators. In one example, the processors may include GPUs, CPUs, DPUs, PPUs, QPUs, and ASICs.

In at least one embodiment, even though illustrated as having one inlet and one outlet or exit for inlet line 210 and for outlet line 212, there may be multiple intermediate lines, such as flexible pipes associating the cold plate with the respective inlet line 210 and outlet line 212. In at least one embodiment, the intermediate lines directly couple the cold plate to the manifold 204 are provided inlet and outlets for such connections. In at least one embodiment, media adapters are provided to allow such coupling. In at least one embodiment, the media adapters are sized to the inlet and outlet provisions in the cold plate and the manifold 204.

FIG. 2A also illustrates that computer module aspects 200 may include a circuit board 222 having interconnect features 224 on a first side (top side, as illustrated) and on a second side (bottom side, similar features as the top side illustrated or soldered features relative to the top side). The interconnect features 224 may couple one or more of the computing components 220A-220D together. The interconnect features 224 may include copper traces, plated and non-plated through-holes, solder points, transmission lines, and electrically-insulating circuit board material over which such copper traces and solder points may lie.

In at least one implementation, a secondary cooling loop 158; 214A; 214B may be used to capture a largest portion of heat generated within the system, while targeting the computing components 220A-220D. For instance, it is possible to capture ambient heat that may be other than the targeted computing components 220A-220D. Therefore, it is possible to capture about 80-90% of heat generated from a computer module or a rack by one or more of the secondary cooling loops 158; 214A; 214B. This is even though the secondary cooling loop 158; 214A; 214B may operate at temperatures that are greater than 0 °C and even though the secondary cooling loop 158; 214A; 214B may operate using a water-based media. Any or all of the illustrated cold plates 210A-210D may be individual flexible cold plate assemblies over the underlying computing components or features 220A-220D.

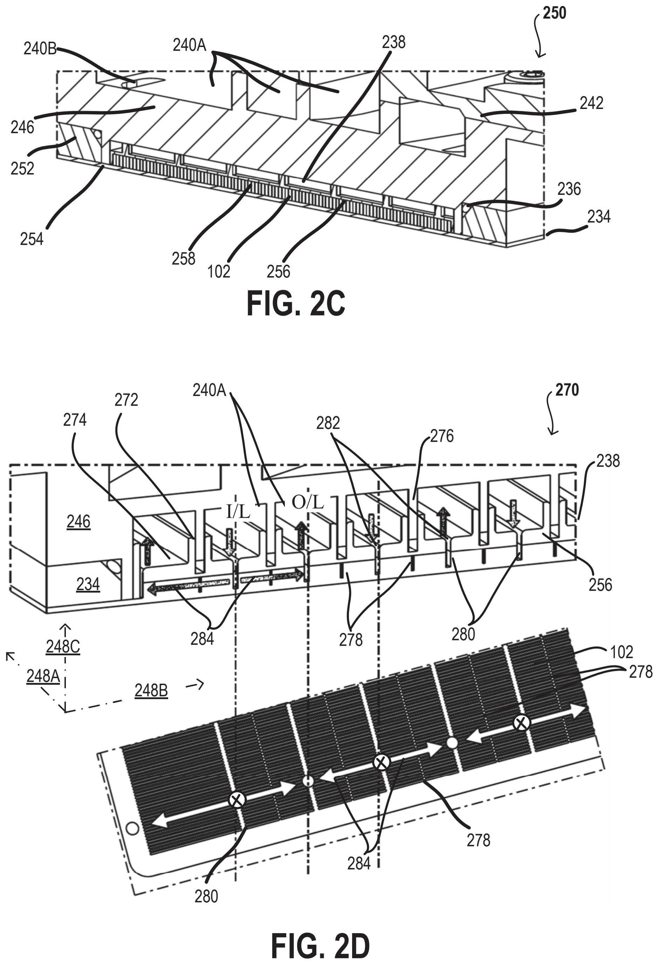

FIG. 2B is an illustration of cross-section aspects 230 of a flexible cold plate assembly 232 that may be any of the cold plates 210A; 210B; 210C; 210D in FIG. 2A, in at least one embodiment. The cross-section aspects 230 are also in the form of an exploded view of the assembled version 232A of the flexible cold plate assembly 232, illustrated in FIG. 2B. The cross-section aspects 230 include a flexible cold plate 234 that may have heat removal surface extensions 102 and may have discontinuities within the heat removal surface extensions 102, as detailed further in connection with at least FIG. 2D herein. The flexible cold plate 234 may be like the flexible cold plate 100H in FIG. 1H or may include elevated boundary areas (detailed further in FIG. 2C). The discontinuities in the heat removal surface extensions 102 may be in a perpendicular direction or axis 248A relative to a direction or axis 248B of the heat removal surface extensions. The discontinuities can allow conformance or flexing, as part of the controlled deformation or along with the controlled deformation, in the flexible cold plate 234 to support warping associated with an underlying computing component 220A; 220B; 220C; 220D.

Further, the cross-section aspects 230 illustrate that a distribution seal 238 may be provided over the flexible cold plate 234. The distribution seal 238 can provide a seal at a first top of the heat removal surface extensions 102 and at a second top of the discontinuities, which is illustrated and detailed further in FIG. 2D. The distribution seal 238 may also be configured as a manifold for further conforming or flexing, relative to the conforming or flexing aspects provided by the flexible cold plate 234. For instance, the further conforming or flexing allows the distribution seal 238 to move with the flexible cold plate. Therefore, the further conforming or flexing may be with respect to conforming or flexing that occurs in the flexible cold plate, as part of the controlled deformation or along with the controlled deformation, and may be with respect to warping that occurs or that is associated with the underlying computing component 220A; 220B; 220C; 220D. There may be at least one O-ring seal 236 between the distribution manifold 246 and flexible cold plate 234 to prevent fluid from exiting the flexible cold plate or the distribution manifold during use of the flexible cold plate assembly 232. Instead of an O-ring seal, there may be at least one of epoxy, adhesive, or a weld between the distribution manifold and flexible cold plate to prevent the fluid from exiting the flexible cold plate or the distribution manifold.

Further, as illustrated, the manifold lid 242 may be fastened to the distribution manifold 246 using fasteners 244, with the manifold lid 242 and the distribution manifold 246 positioned over the distribution seal 238. The fasteners 244 may be threaded and may also extend to the flexible cold plate 234 to provide stiffening in the flexible cold plate assembly 232. The manifold lid 242 may be used to guide fluid from a fluid inlet 242A of the manifold lid 242 to manifold distribution channels 240A of the distribution manifold 246. The manifold distribution channels 240A, in turn, allow the fluid to reach the heat removal surface extensions 102 of the flexible cold plate 234. The fluid may be returned from the heat removal surface extensions 102 to the manifold distribution channels 240A and to the manifold lid 242, prior to being removed from the flexible cold plate assembly 232 via a fluid outlet 242B. The fluid outlet 242B may be a structurally similar opening as the fluid inlet 242A and may be located on an opposite side of the manifold lid 242 relative to the fluid inlet 242A.

FIG. 2C is an illustration of further aspects 250 of a flexible cold plate assembly, in at least one embodiment. As illustrated, the flexible cold plate 234 may include a base plate 254 that may be a thin base of copper material. The flexible cold plate 234 may include elevated boundary areas 252 throughout a perimeter of the flexible cold plate assembly 232. The flexible cold plate 234 may include the heat removal surface extensions 102, which extends along a longer axis 248B of the flexible cold plate 234. Therefore, in FIG. 2C, front edges 258 of the heat removal surface extensions 102 may be visible in a cross-section that is perpendicular to the longer axis 248B and that is parallel to the shorter axis 248A of the flexible cold plate 234.

The thin and flexible base forming the base plate 254 allows for improved cooling of silicon features of the computing components by control of the bond-line thickness of the TIM and to achieve a uniform and controlled bond-line. In one example, the TIM achieved is a thin layer in the order of thickness that may be based at least in part on the thickness of the base plate 254. For example, the TIM is allowed to be a thin layer which is less than 100 microns in thickness. In another example, the TIM is a thin layer in the range of one of: less than 100 microns, 100 microns to 200 microns, 200 microns to 300 microns, 300 microns to 400 microns, or 400 microns to 500 microns.

FIG. 2C also illustrates the distribution seal 238 in a cross-section that is along the shorter axis 248A (as in FIG. 2B) of the flexible cold plate 234. The distribution seal 238 can provide a seal at a top of the heat removal surface extensions 102 at least by virtue of a flat surface on a bottom side 256 of the distribution seal 238 that sits flush against the tops of the heat removal surface extensions 102. This allows the distribution seal 238 to provide a seal at the tops of the heat removal surface extensions 102, to prevent fluid from crossing individual ones of the heat removal surface extensions 102.

The distribution manifold 246 can be over the distribution seal 238 and can include manifold distribution channels 240A to distribute fluid, received into the distribution manifold 246, to the heat removal surface extensions 102. For instance, the manifold distribution channels 240A may include ports 240B to distribute the fluid to at least the distribution seal. As detailed further in connection with at least FIG. 2D, the distribution seal 238 may have inlet ("I/L") and outlet ("O/L") ports for allowing the fluid from the distribution seal 238 to enter and exit the heat removal surface extensions 102.

FIG. 2D is an illustration of cross-sectional and plan view aspects 270 of heat removal surface extensions and cross-cuts that are perpendicular to a direction of flow of a fluid through the heat removal surface extensions in a flexible cold plate assembly, in at least one embodiment. The flexible cold plate 234 may include multiple cross-cuts 278 that may be within the heat removal surface extensions 102 to separate the heat removal surface extensions 102. The cross-cuts 278 may be along direction or an axis 248A which may be a shorter axis of the flexible cold plate 234 and may be perpendicular to a direction or an axis 248B of the heat removal surface extensions 102. The cross-cuts 278 may extend, in a vertical direction or axis 248C (also in FIG. 2B), from a top of the heat removal surface extensions 102 to the base plate 254 of the flexible cold plate 234. The cross-cuts 278 can allow conformance or flexing, as part of the controlled deformation, in the flexible cold plate 234 to support warping associated with an underlying computing component 220A-220D.

A distribution seal 238 may include U-shaped features 272 that are on a top side 274 of the distribution seal 238 and that is opposite to the bottom side 256 of the distribution seal 238. The U-shaped features 272 fit around posts 276 that form part of the manifold distribution channels 240A. The U-shaped features 272 can provide a further seal over at least part of the manifold distribution channels 240A to prevent fluid from crossing between inlet and outlet ports. This further seal is different than the seal provided using the flat surface on the bottom side 256 of the distribution seal 238, where the flat surface is at the top of the heat removal surface extensions 102 and at the top of the cross-cuts 278. The distribution manifold 102 has its manifold distribution channels 240A aligned with distribution seal channels 282 of the distribution seal 238. In turn, the distribution seal channels 282 are aligned with cold plate distribution channels 280 (also 110D, 110E) of the flexible cold plate 234. The manifold distribution channels 240A, the distribution seal channels 282, and the cold plate distribution channels 280 may individually include alternating inlet (cold) or outlet (hot) channels. This allows fluid that is in a cold state, relative to at least a temperature of the underlying computing component (or to active parts of the underlying computing component), to be received ("X" annotations in FIG. 2D) into the heat removal surface extensions 102 and to exit ("O" annotations in FIG. 2D) from the heat removal surface extensions 102 through different paths.

The fluid flows along the illustrated paths 284 of the heat removal surface extensions 102 after entering into the cold plate distribution channels 280, from the inlet to the outlet within each of the channels, 240A, 282, and 280. As the tops of the heat removal surface extensions 102 and the cross-cuts 278 are sealed by at least the bottom side 256 of the distribution seal 238, the fluid is ensured to be within the paths 284 provided. The distribution seal 238 is configured for further conforming or flexing, and as part of the controlled deformation and with respect to the flexible cold plate and as part of the controlled deformation, upon warping associated with the underlying computing component. For instance, the distribution seal 238 is a rubber or other gasket material and is capable of conforming or flexing by the nature of the rubber or other gasket material. Further, the distribution seal 238 can slide relative to the distribution manifold 246 as needed, upon displacement caused in part by the base plate 254 upon warping associated with the underlying computing component 220A and to be conforming or flexing to the warping.

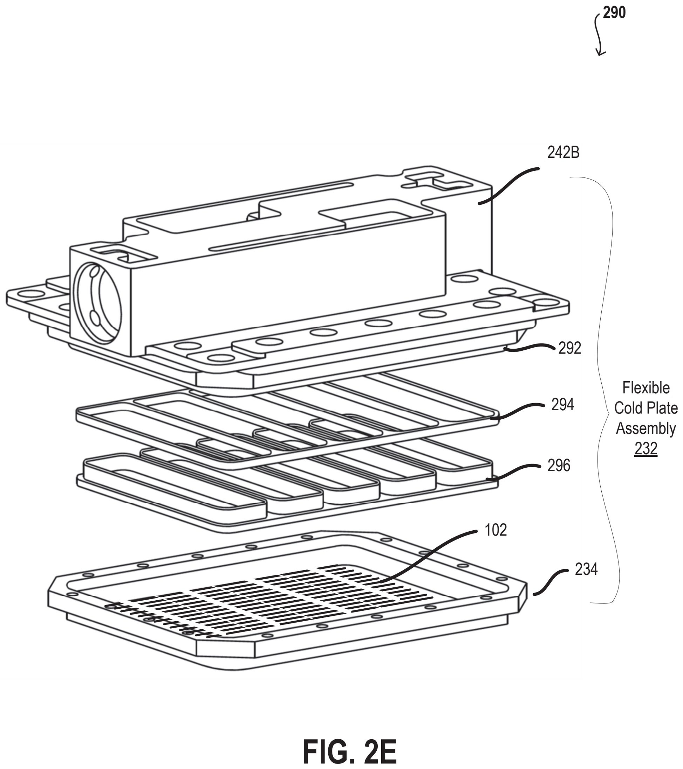

FIG. 2E is an illustration of cross-sectional view aspects 290 of a distribution seal having a top distribution seal portion and a bottom distribution seal portion, in at least one embodiment. The cross-sectional view aspects 290 include, in a manner similar to FIG. 2B, a manifold lid 242 that may be fastened to a distribution manifold 292. The distribution manifold 292 may have slightly different distribution manifold channels to align with a distribution seal 294, 296 provided in two portions and provided with bridging therebetween instead of having a perimeter seal as illustrated in FIG. 2B. Fasteners may be used between the manifold lid 242 and the distribution manifold 292 positioned over the distribution seal 294, 296. The fasteners may also extend to the flexible cold plate 234 to provide stiffening in the flexible cold plate assembly 232. The manifold lid 242 may be used to guide fluid from a fluid inlet of the manifold lid 242 to manifold distribution channels of the distribution manifold 292. The manifold distribution channels, in turn, allow the fluid to reach the heat removal surface extensions 102 of the flexible cold plate 234 that may have a slightly different structure to support the distribution seal in portions, but that may have one or more of at least the discontinuities or the thin base plate. A top distribution seal portion 294 and a bottom distribution seal portion 296 may be provided. The bottom distribution seal portion 296 may be provided to allow the seal at the first top of the heat removal surface extensions and the second top of the discontinuities. The top seal distribution portion 294 may provide a further seal between the distribution manifold 292 and the bottom distribution seal portion 296.

FIG. 3A is an illustration of a flexible cold plate assembly 300 with a distribution seal having flow restrictions to block or limit fluid from reaching portions of the flexible cold plate in a flexible cold plate assembly, in at least one embodiment. The distribution seal 312, in one embodiment, may include the illustrated flow restrictions 302 to block or limit fluid that enter the cold plate distribution channels 280 from reaching portions 310A of the flexible cold plate 304 associated with a passive or less active part 308 of the underlying computing component 220A. In at least one embodiment, the flow restrictions 302 may be extensions of the distribution seal 312. However, in at least one embodiment, the flow restrictions 302 may not be an extension and may remain a flat surface 302A that is even along with portions of the distribution seal 312 that are only at the tops of the heat removal surface extensions 102. In addition, the flow restrictions 302 may be extensions that may be partly within the gaps of the heat removal surface extensions 102. However, providing the flow restrictions 302 fully in the gaps, in one example, may be so that fluid pockets are not formed. The partial or flat surface 302A may be used to allow slower than usual flow (limited flow) through portions 310A of the flexible cold plate 304 associated with a passive or less active part 308 of the underlying computing component 220A.

The passive or less active part 308 may be associated with a lower activity measure relative to at least one active part 306 of the underlying computing component 220A, which may receive cooling for being under a portion 310B of the flexible cold plate 304 that has no blocking or limitation to the fluid. Therefore, the distribution seal 312 may be different or may include additional features (such as the flow restrictions 302), relative to the distribution seal 238 in FIGS. 2B-2D herein. Similarly, the flexible cold plate 304 may be different or may include additional features (such as spacing in one or more of the heat removal surface extensions, the cold plate distribution channels, or the cross-cuts to allow flow restrictions 302), relative to the flexible cold plate 234 in FIGS. 2B-2D herein.

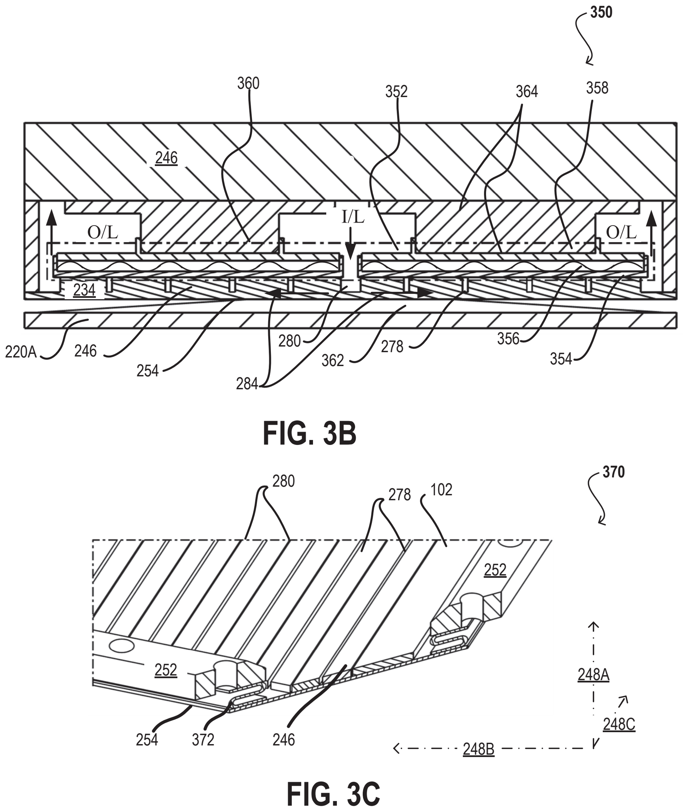

FIG. 3B is a detailed illustration of a flexible cold plate assembly 350 with a distribution seal having a spring between a top plate and a bottom plate to perform further conforming or flexing in the distribution seal of a flexible cold plate assembly, in at least one embodiment. In FIG. 3B, it is apparent that reference to heat removal surface extensions 102 is to separations not illustrated that may be fins or other types of heat removal surface extensions. Similarly, the distribution manifold 246 is not generally illustrated and includes distribution channels, even if not illustrated in this figure, it is apparent from the descriptions and illustrates throughout herein. The flexible cold plate assembly 350 may include a different distribution seal 360 or further features in a distribution seal, relative to the distribution seal 238 in FIGS. 2B-2D herein. For instance, the distribution seal 360 may include a top plate 358 and a bottom plate 354. At least the bottom plate 354 can allow a seal at the first top of the heat removal surface extensions 102 and at the second top of the cross-cuts 278. The top plate 358 and the bottom plate 354 may support the cold plate distribution channels inlet (I/L) and outlet (O/L) 280 for fluid through the distribution manifold 246. For instance, the top plate 358 can provide a distribution channel seal, using its top side 352 which is against the distribution seal channels 282 of the distribution manifold 246. In turn, the cold plate distribution channels I/L and O/L 280 support flow through paths 284, along the heat removal surface extensions 102, as described in connection with at least FIG. 2D herein.

There may be a spring 356 provided between the top plate 358 and the bottom plate 354. The spring can allow one or more of the top plate 358 and the bottom plate 354 to perform a further conforming or flexing in the distribution seal 360, with respect to the flexible cold plate 234, upon warping 362 associated with the underlying computing component 220A. In one example, the bottom plate 354 may be configured to move along a vertical direction or axis 248C to be closer or farther with respect to the top plate 358, as part of the further conforming or flexing in the distribution seal 360. Alternatively, instead of movement, one or more of the top plate 358 and the bottom plate 354 may only flex, as assisted by the spring 356. As such, the spring may be formed from steel, copper, or other suitable material capable of spring-like action. In at least one embodiment, the top plate 358 and the distribution manifold 246 may be part of stationary structures 364 and the flex or movement may be only in the bottom plate 354.

Further, in assembly methodology, diffusion bonding may be performed for bonding together similar materials while leaving certain dissimilar materials as intended within the assembly. For instance, a temperature of the similar materials may be raised as close to a melting point for the similar materials to provide bonding. Such an approach may be used to bond, for instance, a top plate to the distribution channels, while allowing the bottom plate to be unbonded with respect to the heat removal surface extensions. This leaves the bottom plate with a conforming or flexing capability, as part of the controlled deformation, even if it seals the tops of the heat removal surface extensions. Therefore, the bottom plate, the top plate, and the heat removal surface extensions may be provided with different materials so that they do not bond in a diffusion bonding process. Meanwhile, the distribution channels may be of similar materials as the top plate so that these neighboring materials may be subject to a diffusion bond. Therefore, it is possible to cause diffusion bonding to occur at some part of a distribution seal as against other parts that are able to conform or flex with respect to the bonded parts. For instance, diffusion bonding may be used to bond the flexible metal bellow 372 to the base plate 254 and to the elevated boundary areas 252. Separately, brazing and laser welding are other options to provide one or more of the bonding aspects described throughout herein.

FIG. 3C is an illustration of features 370 to provide conformance or flexing in boundary areas of a flexible cold plate, in at least one embodiment. While at least in FIG. 2C, the flexible cold plate 234 may have elevated boundary areas 252, a thin base plate 254 of the bottom of the flexible cold plate 234 having the heat removal surface extensions 102, the cold plate distribution channels I/L and O/L 280, and the cross-cuts 278 may incorporate sufficient conformance or flexibility to any warping or non-flat silicon features in a center of the underlying computing component. However, there may be resulting stress on a perimeter of the flexible cold plate assembly 232. This may be at least because the elevated boundary areas 252 may not be able to conform or flex due to bonding to ridged components needed to complete the flexible cold plate assembly 232. The existence of internal fluid pressures may exacerbate this resulting stress.

In at least one embodiment, as in FIG. 3C, a flexible metal bellow 372 may extend throughout the perimeter of the flexible cold plate assembly 232. The flexible metal bellow 372 may be an S or other serpentine shaped feature to provide a mechanical connection that can create a robust fluid seal joining the elevated boundary areas 252 to the base plate 254 (or joining different layers of at least the perimeter of the flexible cold plate assembly 232). The flexible metal bellow 372 can also distribute any deflection and stress for all the different internal and external loads experienced in the flexible cold plate assembly 232. When the flexible metal bellow 372 is provided in a flexible cold plate assembly 232, the elevated boundary areas 252 may be such that it acts as a stiffener for the flexible cold plate assembly 232.

In at least one embodiment, the flexible cold plate assembly herein may include a flexible cold plate which allows for conformance or flexing to support warping associated with an underlying computing component and the controlled deformation. The conformance or flexing may be based, at least in part, on heat removal surface extensions provided over a base plate having a thickness that is preferably within a range which is between one of 150 to 200 microns, 200 to 300 microns, 300 to 400 microns, or 400 to 500 microns, wherein each of such ranges represent a thin base plate discussed throughout herein. The lower end of such ranges may present lesser reliance on cross-cuts, in at least one example. The lower end of such ranges may also present lesser reliance on a distribution seal having a flexing or conformance to a degree, in another example. In at least one embodiment, the conformance or flexing to support warping associated with an underlying computing component may be based, at least in part, on heat removal surface extensions provided over a base plate having a thickness of between 150 microns and 500 microns, may be additionally based, at least in part, on the heat removal surface extensions having cross-cuts therein, wherein the cross-cuts are perpendicular to a direction of flow of a fluid through the heat removal surface extensions, and may be additionally based, at least in part, on the distribution seal having further conformance or flexibility by a material used in the distribution seal.

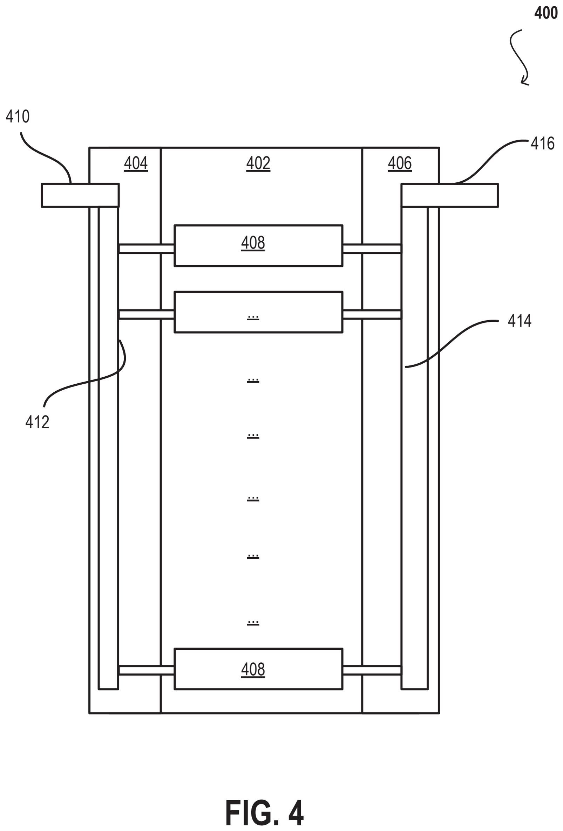

FIG. 4 illustrates rack aspects 400 in a system subject to a flexible cold plate assembly, according to at least one embodiment. A rack 402 has brackets 404, 406, to allow hanging of one or more cooling loop components within the rack 402. In at least one embodiment, rack manifolds 412, 414 may be provided to guide media from row manifolds to the computer modules 408 with the rack 402. The entry rack manifold 412 may pass media of a secondary cooling loop from the row manifolds through conduit 410, through the computer modules 408 that may be in a server tray or box form-factor, out of the egress rack manifold 414, and back into the row manifold via the egress conduit 416. The flexible cold plate assemblies herein may be used in any of the illustrated server tray or box forming the computer modules 408 and may also benefit from additional local distribution units if there is a need to increase pressure of media flow at any level of a rack.

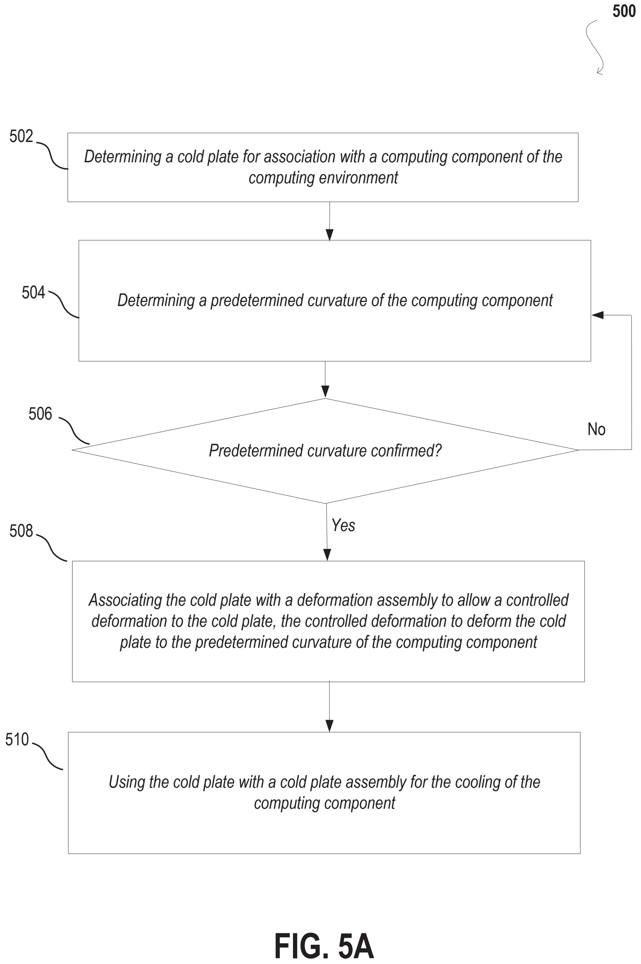

FIG. 5A illustrates a process flow or method 500 for a deformation assembly to include a cold plate and to allow a controlled deformation to the cold plate, in at least one embodiment. The method 500 may be for cooling in a computing environment. The method may include a step for determining 502 a cold plate for association with a computing component of the computing environment. The method 500 may include a step for determining 504 a predetermined curvature of the computing component. A step for confirming the predetermined curvature may be performed; and, once confirmed 506, the method 500 may include a step for associating 508 the cold plate with a deformation assembly. The deformation assembly may allow a controlled deformation to the cold plate under this step. The controlled deformation may be to pre-deform the cold plate inward to the predetermined curvature of the computing component. The method 500 may include a step of using 510 the cold plate with a cold plate assembly for the cooling of the computing component.

The method 500 may include a step of allowing the controlled deformation to the cold plate within the deformation assembly using one or more of a top plate, a bottom plate, or an integrated plate of the deformation assembly. The method 500 may include this step as part of the associating 508 step. The method 500 may include a step for performing, using a mechanical sub-system or a pressure-based sub-system, the controlled deformation for the cold plate, also as part of the associating 508 step. The performing step may be through the one or more of the top plate, the bottom plate, or the integrated plate. The controlled deformation may be to cause the predetermined curvature of a computing component for the cold plate.

As part of the determining 504 step in the method 50, a step may be included for receiving, to a modeling sub-system, information associated with a curvature of the computing component. The method 500 may include a step for modeling the curvature of the computing component from the information. The method 500 may include a step for allowing the predetermined curvature to cause the controlled deformation for the cold plate using the mechanical sub-system or the pressure-based sub-system. The cold plate may be a flexible cold plate having one or more of discontinuities in its heat removal surface extensions or a base plate having a thickness in a range which is between 100 to 500 microns.

The method 500 may include a step for attaching one or more spacers to a surface of the computing component in a pattern according to the predetermined curvature. This may be part of the associating 508 step. The one or more spacers may be thermally-conductive to be coupled to the cold plate. The method 500 may include a step for applying a bonding material over the one or more spacers. The method 500 may include a step for flowing the bonding material. The method 500 may include a step for applying a force from the mechanical sub-system or the pressure-based sub-system to cause the controlled deformation of the cold plate and to cause the cold plate to be bonded to the surface of the computing component, over the spacers and the bonding material. All such steps for the spacers may be part of at least the associating 508 step of the method 500.

The method 500 may include a step for allowing the deformation assembly to support the cold plate assembly or to be part of the cold plate assembly by at least a portion of the deformation assembly remaining part of the cold plate assembly, after the controlled deformation of the cold plate and when the computing component is used to perform a workload. The method 500 may include a step for providing an allowance in a top plate of the deformation assembly. The allowance may be for a pressure-based sub-system. The method 500 may include a step for providing a bottom profile for a bottom plate of the deformation assembly. The bottom profile may include the predetermined curvature. The method 500 may include a step for providing, by the pressure-based sub-system, pressure through the allowance as the controlled deformation applied to the cold plate.

The method 500 may include a step for removing the cold plate from the deformation assembly. The method 500 may include a step for associating the cold plate with the cold plate assembly and the computing component. The cold plate assembly may be used for the cooling of the computing component when the computing component is used to perform a workload. At least the steps of removing the cold plate from the deformation assembly, associating the cold plate with the cold plate assembly, and using the cold plate assembly for the cooling in the method 500, may be part of the using 510 step in the method 500.

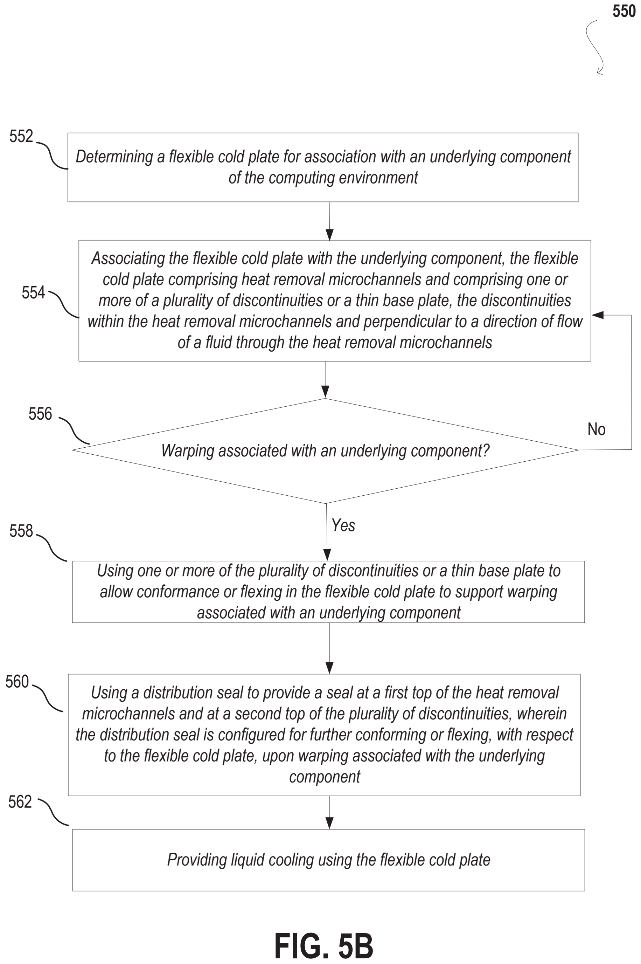

FIG. 5B illustrates a process flow or method 550 for a system having at least one flexible cold plate assembly, in at least one embodiment. The method 550 of FIG. 5B may be used alone or in combination with the method 500 of FIG. 5A by detailing further steps or sub-steps for the method 500 in FIG. 5A. The method 550 may include determining 552 a flexible cold plate for association with an underlying computing component of the computing environment. The determining 552 herein may take into account layouts (or design) of the underlying computing component, including its active and less active or passive parts. The determining 552 may also take into account an amount of flexing or conforming required or an amount of warping that may be caused in the underlying computing components. The determining 552 may also take into account temperatures associated with the underlying computing component and the fluid to be used in a liquid cooling system to be associated with the flexible cold plate.

The method 550 may include associating 554 the flexible cold plate with the underlying computing component. The flexible cold plate may include heat removal surface extensions and may include one or more of discontinuities, such as cross-cuts within the heat removal surface extensions, or a thin base plate. The discontinuities in the heat removal surface extensions may be perpendicular to a direction of flow of a fluid through the heat removal surface extensions. The method 550 may include determining or verifying 556 warping associated with an underlying computing component. This may be in support of the determining 552 step, in one example. The method 550 may include using 558 one or more of the discontinuities or the thin base plate to allow conformance or flexing in the flexible cold plate to support warping associated with an underlying computing component. For instance, a predetermined number of discontinuities may be associated with a measure of the warping expected in the underlying computing component or may be based in part on a size of the underlying computing component.

The method 550 may include using 560 a distribution seal to provide a seal at a first top of the heat removal surface extensions and at a second top of the plurality of discontinuities. The distribution seal may be configured for further conforming or flexing, with respect to the flexible cold plate, upon warping associated with the underlying computing component. The method 550 may include providing 562 the liquid cooling using the flexible cold plate and using fluid that may be predetermined for cooling the underlying computing component upon generation of heat during performing of a workload. In one example, the fluid may be provided at all times, irrespective of the heat generated or the workload being performed.

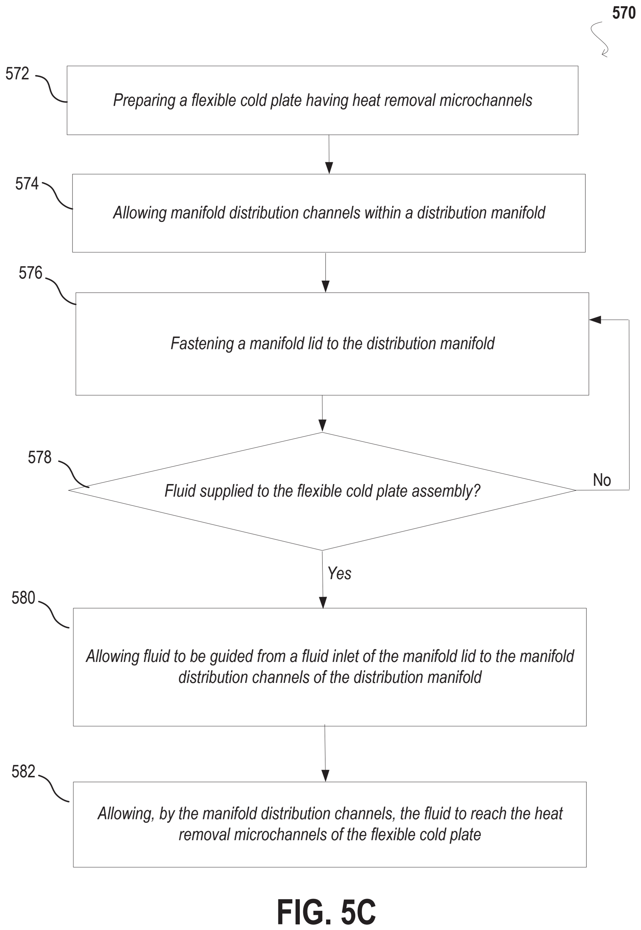

FIG. 5C illustrates yet another process flow or method 570 for a system having at least one flexible cold plate assembly, in at least one embodiment. The method 570 of FIG. 5C may be used alone or in combination with the method 500 of FIG. 5A and/or the method 550 of FIG. 5B, by detailing further steps or sub-steps for the methods 500, 550 in FIGS. 5A and 5B. The method 570 may include preparing 572 a flexible cold plate having heat removal surface extensions. The step of preparing 572 may include determining, machining, and designing the flexible cold plate to suit an application within an underlying computing component.

The method 570 may include allowing 574 manifold distribution channels within the distribution manifold. The step of allowing 574 such manifold distribution channels may include a preparing step in the manner of the preparing step 572 of the flexible cold plate and may also include sub-steps or steps for determining, machining, and designing of the distribution manifold to include the manifold distribution channels. In one example, the distribution manifold has to align with the flexible cold plate and, therefore, it is apparent that one or more steps in the methods 500, 550, 570 of FIGS. 5A, 5B, 5C may be performed in a different order or by interchanging or repeating steps within the generally provided method steps.

The method 570 may include fastening 576 a manifold lid to the distribution manifold. This or any of such steps in the methods herein may include verification or determining that proper O-ring seals are put in place before one or more fastening or attaching steps are performed. The method 570 may include determining or verifying 578 that fluid is supplied to the flexible cold plate assembly. The flexible cold plate assembly incorporating at least steps 572-574 supports allowing 580 fluid to flow from a fluid inlet of the manifold lid, through one or more ports of a distribution manifold that is between the manifold lid and the distribution seal, and through the manifold distribution channels, the distribution seal channels, and the cold plate distribution channels. The flexible cold plate assembly incorporating at least steps 572-574 also supports allowing 580 fluid to be guided from a fluid inlet of the manifold lid to the manifold distribution channels of the distribution manifold. The method 570 may include allowing 582, by the manifold distribution channels, the fluid to reach the heat removal surface extensions of the flexible cold plate.

The method 500; 550; 570 herein may include a step or sub-steps for providing a distribution manifold to be over the distribution seal and having therein manifold distribution channels. The method may include allowing U-shaped features on a top side of the distribution seal to provide a further seal over at least part of the manifold distribution channels. The method may include allowing a flat surface on a bottom side of the distribution seal to provide the seal at the first top of the heat removal surface extensions and the second top of the plurality of cross-cuts. The method may include using the distribution manifold to distribute fluid through the distribution seal and into the heat removal surface extensions, in support of steps 562 and 582 of the method or methods herein.

The method 500; 550; 570 herein may incorporate a step of using at least one O-ring seal between the distribution manifold and flexible cold plate to prevent fluid from exiting the flexible cold plate or the distribution manifold. The method 550; 570 herein may include steps or sub-steps for fastening a manifold lid to a distribution manifold and over the distribution seal, and for allowing fluid to be guided from a fluid inlet of the manifold lid to manifold distribution channels of the distribution manifold. The manifold distribution channels can allow the fluid to reach the heat removal surface extensions of the flexible cold plate. The method 550; 570 herein may include a step or sub-steps for determining portions of the flexible cold plate that are associated with a passive or less active part of the underlying computing component. The passive or less active part may be associated with a lower activity measure relative to at least one active part of the underlying computing component. The method 550; 570 herein may include a step or sub-steps for allowing flow restrictions in the distribution seal to block or limit fluid from reaching portions of the flexible cold plate associated with the passive or less active part of the underlying computing component.

The method 500; 550; 570 herein may incorporate a step for allowing the distribution seal to include a top plate, a bottom plate, and a spring which is between the top plate and the bottom plate. The method 500; 550; 570 herein may incorporate a step for allowing the bottom plate for the seal at the first top of the heat removal surface extensions and at the second top of the plurality of cross-cuts. The method herein may include allowing, using the spring, one or more of the top plate and the bottom plate to perform the further conforming or flexing in the distribution seal, with respect to the flexible cold plate, upon warping associated with the underlying computing component. Further, the method 500; 550; 570 herein may be such that the bottom plate is configured to vertically move closer or farther with respect to the top plate, as part of the further conforming or flexing in the distribution seal.

A flexible cold plate herein may include adjustable fins forming microchannels for fluid to flow through. In at least one embodiment, fins in a cold plate enable transfer of heat from at least one associated computing component to a fluid flowing through microchannels formed between multiple fins. In at least one embodiment, fins of a cold plate are dynamically and adjustable in real time to allow transfer of more heat from at least one computing component to a fluid that flows through a cold plate having fins. In at least one embodiment, such fins may be adjusted by a processor or processorless system based in part on a temperature determined, such as sensed, for a cold plate. In at least one embodiment, a temperature may be associated with at least one computing component, a workload of at least one computing component, or a fluid at different time periods and at an entry, and at an egress of a cold plate. In at least one embodiment, a processorless system may rely on a thermal property of at least two materials used to form fins for a cold plate so that such fins may react without a processor to cause exposure of more surface area to a fluid. In at least one embodiment, such fins may include an overlapping portion that may be caused to be exposed by action of a control mechanism or by properties of at least two materials associated together to form a fin.

It will be understood that aspects and embodiments are described herein purely by way of example, and that modifications of detail can be made within the scope of the claims.

Each apparatus, method, and feature disclosed in the description, and (where appropriate) the claims and drawings may be provided independently or in any appropriate combination.

Reference numerals appearing in the claims are by way of illustration only and shall have no limiting effect on the scope of the claims.

The disclosure of this application also includes the following numbered clauses:
Clause 1. A deformation assembly comprising a cold plate and to allow a controlled deformation to the cold plate, the controlled deformation to deform the cold plate to a predetermined curvature.
Clause 2. The deformation assembly of clause 1, wherein the predetermined curvature is from a modelling of a curvature of a computing component.
Clause 3. The deformation assembly of clause 1, further comprising:
   a top plate with an allowance for a pressure-based sub-system; and
   a bottom plate, wherein the pressure-based sub-system is to provide a positive or negative pressure through the allowance to allow the controlled deformation to the cold plate based in part on the predetermined curvature.
Clause 4. The deformation assembly of clause 2, wherein at least a portion of the deformation assembly remains part of a cold plate assembly comprising the cold plate, after the controlled deformation of the cold plate and when the computing component is used to perform a workload.
Clause 5. The deformation assembly of clause 2, further comprising:
   a top plate or an integrated plate to associate with the cold plate and to allow a mechanical shaping at a bottom surface of a base plate of the cold plate, the mechanical shaping to cause the controlled deformation applied to the cold plate, the mechanical shaping to physically cut or deform only the bottom surface of the base plate to the predetermined curvature of the computing component; or
   a bottom plate or the integrated plate comprising a bottom profile associated with the predetermined curvature of the computing component and to allow the mechanical shaping at the bottom surface of the base plate of the cold plate, the mechanical shaping by pressure between the cold plate and the bottom plate or the integrated plate to cause the controlled deformation to only the bottom surface of the base plate, based at least in part on the bottom profile.
Clause 6. The deformation assembly of clause 2, wherein the cold plate is removable from the deformation assembly and provided within a cold plate assembly with the computing component, and wherein the cold plate assembly is used with the computing component when the computing component is used to perform a workload.
Clause 7. The deformation assembly of clause 2, further comprising:
   one or more spacers, a bonding material, and an allowance for one or more of a mechanical sub-system or a pressure-based sub-system, wherein the one or more spacers are attached to a surface of the computing component in a pattern according to the predetermined curvature and are thermally-conductive to be coupled to the cold plate, and wherein the bonding material is applied over the one or more spacers and allowed to flow, along with a force from the mechanical sub-system or the pressure-based sub-system, to cause the controlled deformation of the cold plate and to cause the cold plate to be bonded to the surface of the computing component, over the spacers and the bonding material.
Clause 8. The deformation assembly of clause 1, wherein the cold plate is a flexible cold plate comprising one or more of discontinuities in its heat removal surface extensions or a base plate having a thickness in a range which is between 100 to 500 microns.
Clause 9. A cold plate assembly comprising a flexible cold plate and comprising a controlled deformation imparted to the flexible cold plate, wherein the flexible cold plate comprises one or more of discontinuities in its heat removal surface extensions or a base plate having a thickness in a range which is between 100 to 500 microns, and wherein the controlled deformation is represented by a predetermined curvature that is associated with a computing component and that is imparted to at least the base plate of the flexible cold plate.
Clause 10. The cold plate assembly of clause 9, wherein the predetermined curvature is from a modelling of a curvature of the computing component.
Clause 11. The cold plate assembly of clause 9, wherein the controlled deformation is performed in a deformation assembly comprising:
   a top plate with an allowance for a pressure-based sub-system; and
   a bottom plate with a bottom profile having the predetermined curvature, wherein the pressure-based sub-system is to provide a positive, zero, or negative pressure through the allowance as the controlled deformation applied to the flexible cold plate.
Clause 12. The cold plate assembly of clause 11, wherein at least a portion of the deformation assembly remains part of the cold plate assembly, after the controlled deformation of the flexible cold plate and when the computing component is used to perform a workload.
Clause 13. The cold plate assembly of clause 9, further comprising:
   one or more spacers, a bonding material, and an allowance for one or more of a mechanical sub-system or a pressure-based sub-system, wherein the one or more spacers are attached to a surface of the computing component in a pattern according to the predetermined curvature and are thermally-conductive to be coupled to the flexible cold plate, and wherein the bonding material is applied over the one or more spacers and allowed to flow, along with a force from the mechanical sub-system or the pressure-based sub-system, to cause the controlled deformation of the flexible cold plate and to cause the flexible cold plate to be bonded to the surface of the computing component, over the spacers and the bonding material.
Clause 14. The cold plate assembly of clause 9, further comprising:
   at least a portion of a deformation assembly, wherein the deformation assembly allows the controlled deformation imparted to the flexible cold plate, and wherein at least the portion of the deformation assembly remains within the cold plate assembly, after the controlled deformation of the flexible cold plate and when the computing component is used to perform a workload.
Clause 15. A system of a cold plate assembly, comprising:
   a deformation assembly to support the cold plate assembly or to be part of the cold plate assembly, the deformation assembly to comprise a cold plate;
   one or more of a top plate, a bottom plate, or an integrated plate to allow a controlled deformation to a cold plate within the deformation assembly; and
   a mechanical sub-system or a pressure-based sub-system to perform the controlled deformation for the cold plate through the one or more of the top plate, the bottom plate, or the integrated plate, the controlled deformation to cause a predetermined curvature of a computing component for the cold plate.
Clause 16. The system of clause 15, further comprising:
   a modeling sub-system to receive information associated with a curvature of the computing component, to model the curvature of the computing component from the information, and to allow the predetermined curvature for the mechanical sub-system or the pressure-based sub-system to perform the controlled deformation for the cold plate.
Clause 17. The system of clause 15, wherein at least a portion of the deformation assembly remains part of the cold plate assembly, after the controlled deformation of the cold plate and when the computing component is used to perform a workload.
Clause 18. A method for cooling in a computing environment, the method comprising:
   determining a cold plate for association with a computing component of the computing environment;
   determining a predetermined curvature of the computing component;
   associating the cold plate with a deformation assembly, the deformation assembly to allow a controlled deformation to the cold plate, the controlled deformation to deform the cold plate to the predetermined curvature of the computing component; and
   using the cold plate with a cold plate assembly for the cooling of the computing component.
Clause 19. A silicon package comprising a cold plate and comprising controlled deformation in the cold plate, the controlled deformation represented by a predetermined curvature of a computing component of the silicon package and which is imparted to at least a base plate of the cold plate.
Clause 20. A datacenter comprising:
   one or more racks comprising one or more server trays;
   at least one computing component in the one or more racks, the at least one computing component to perform at least part of a workload in the datacenter; and
   a cold plate assembly comprising a flexible cold plate and comprising a controlled deformation imparted to the flexible cold plate, wherein the flexible cold plate comprises one or more of discontinuities in its heat removal surface extensions or a base plate having a thickness in a range which is between 100 to 500 microns, and wherein the controlled deformation is represented by a predetermined curvature that is associated with the at least one computing component and that is in imparted to at least the base plate of the flexible cold plate.

## Claims

1. A deformation assembly comprising a cold plate and to allow a controlled deformation to the cold plate, the controlled deformation to deform the cold plate to a predetermined curvature.

2. The deformation assembly of claim 1, wherein the predetermined curvature is from a modelling of a curvature of a computing component, further comprising:
a top plate with an allowance for a pressure-based sub-system; and
a bottom plate, wherein the pressure-based sub-system is to provide a positive or negative pressure through the allowance to allow the controlled deformation to the cold plate based in part on the predetermined curvature.

3. The deformation assembly of claim 2, wherein at least a portion of the deformation assembly remains part of a cold plate assembly comprising the cold plate, after the controlled deformation of the cold plate and when the computing component is used to perform a workload.

4. The deformation assembly of claim 2, further comprising:
a top plate or an integrated plate to associate with the cold plate and to allow a mechanical shaping at a bottom surface of a base plate of the cold plate, the mechanical shaping to cause the controlled deformation applied to the cold plate, the mechanical shaping to physically cut or deform only the bottom surface of the base plate to the predetermined curvature of the computing component; or
a bottom plate or the integrated plate comprising a bottom profile associated with the predetermined curvature of the computing component and to allow the mechanical shaping at the bottom surface of the base plate of the cold plate, the mechanical shaping by pressure between the cold plate and the bottom plate or the integrated plate to cause the controlled deformation to only the bottom surface of the base plate, based at least in part on the bottom profile.

5. The deformation assembly of claim 2, wherein the cold plate is removable from the deformation assembly and provided within a cold plate assembly with the computing component, and wherein the cold plate assembly is used with the computing component when the computing component is used to perform a workload.

6. The deformation assembly of claim 2, further comprising:
one or more spacers, a bonding material, and an allowance for one or more of a mechanical sub-system or a pressure-based sub-system, wherein the one or more spacers are attached to a surface of the computing component in a pattern according to the predetermined curvature and are thermally-conductive to be coupled to the cold plate, and wherein the bonding material is applied over the one or more spacers and allowed to flow, along with a force from the mechanical sub-system or the pressure-based sub-system, to cause the controlled deformation of the cold plate and to cause the cold plate to be bonded to the surface of the computing component, over the spacers and the bonding material.

7. The deformation assembly of any preceding claim, wherein the cold plate is a flexible cold plate comprising one or more of discontinuities in its heat removal surface extensions or a base plate having a thickness in a range which is between 100 to 500 microns.

8. A cold plate assembly comprising a flexible cold plate and comprising a controlled deformation imparted to the flexible cold plate, wherein the flexible cold plate comprises one or more of discontinuities in its heat removal surface extensions or a base plate having a thickness in a range which is between 100 to 500 microns, and wherein the controlled deformation is represented by a predetermined curvature that is associated with a computing component and that is imparted to at least the base plate of the flexible cold plate.

9. The cold plate assembly of claim 8, wherein the predetermined curvature is from a modelling of a curvature of the computing component, wherein the controlled deformation is performed in a deformation assembly comprising:
a top plate with an allowance for a pressure-based sub-system; and
a bottom plate with a bottom profile having the predetermined curvature, wherein the pressure-based sub-system is to provide a positive, zero, or negative pressure through the allowance as the controlled deformation applied to the flexible cold plate, wherein at least a portion of the deformation assembly remains part of the cold plate assembly, after the controlled deformation of the flexible cold plate and when the computing component is used to perform a workload.

10. The cold plate assembly of claim 8, further comprising:
at least a portion of a deformation assembly, wherein the deformation assembly allows the controlled deformation imparted to the flexible cold plate, and wherein at least the portion of the deformation assembly remains within the cold plate assembly, after the controlled deformation of the flexible cold plate and when the computing component is used to perform a workload.

11. A system of a cold plate assembly, comprising:
a deformation assembly to support the cold plate assembly or to be part of the cold plate assembly, the deformation assembly to comprise a cold plate;
one or more of a top plate, a bottom plate, or an integrated plate to allow a controlled deformation to a cold plate within the deformation assembly; and
a mechanical sub-system or a pressure-based sub-system to perform the controlled deformation for the cold plate through the one or more of the top plate, the bottom plate, or the integrated plate, the controlled deformation to cause a predetermined curvature of a computing component for the cold plate.

12. The system of claim 11, further comprising:
a modeling sub-system to receive information associated with a curvature of the computing component, to model the curvature of the computing component from the information, and to allow the predetermined curvature for the mechanical sub-system or the pressure-based sub-system to perform the controlled deformation for the cold plate, wherein at least a portion of the deformation assembly remains part of the cold plate assembly, after the controlled deformation of the cold plate and when the computing component is used to perform a workload.

13. A method for cooling in a computing environment, the method comprising:
determining a cold plate for association with a computing component of the computing environment;
determining a predetermined curvature of the computing component;
associating the cold plate with a deformation assembly, the deformation assembly to allow a controlled deformation to the cold plate, the controlled deformation to deform the cold plate to the predetermined curvature of the computing component; and
using the cold plate with a cold plate assembly for the cooling of the computing component.

14. A silicon package comprising a cold plate and comprising controlled deformation in the cold plate, the controlled deformation represented by a predetermined curvature of a computing component of the silicon package and which is imparted to at least a base plate of the cold plate.

15. A datacenter comprising:
one or more racks comprising one or more server trays;
at least one computing component in the one or more racks, the at least one computing component to perform at least part of a workload in the datacenter; and
a cold plate assembly comprising a flexible cold plate and comprising a controlled deformation imparted to the flexible cold plate, wherein the flexible cold plate comprises one or more of discontinuities in its heat removal surface extensions or a base plate having a thickness in a range which is between 100 to 500 microns, and wherein the controlled deformation is represented by a predetermined curvature that is associated with the at least one computing component and that is in imparted to at least the base plate of the flexible cold plate.
